Europäisches Patentamt

European Patent Office

Office européen des brevets

(19)

(11) **EP 0 241 204 B1**

(12) ## EUROPEAN PATENT SPECIFICATION

(45) Date of publication and mention
of the grant of the patent:
**28.08.1996 Bulletin 1996/35**

(51) Int Cl.6: **H01L 21/20**, H01L 21/205,
C30B 25/04

(21) Application number: **87302786.6**

(22) Date of filing: **31.03.1987**

(54) **Method for forming crystalline deposited film**

Herstellungsverfahren einer niedergeschlagenen Kristallschicht

Méthode pour former une couche cristalline déposée

(84) Designated Contracting States:
**AT BE CH DE ES FR GB GR IT LI LU NL SE**

(30) Priority: **31.03.1986 JP 73093/86**
**20.03.1987 JP 67336/87**

(43) Date of publication of application:
**14.10.1987 Bulletin 1987/42**

(73) Proprietor: **CANON KABUSHIKI KAISHA**
**Tokyo (JP)**

(72) Inventors:
• **Matsuyama, Jinsho**
**Nagahama-shi, Shiga-ken, (JP)**
• **Hirai, Yutaka**
**Hikone-shi, Shiga-ken, (JP)**
• **Ueki, Masao**
**Urayasu-shi, Chiba-ken, (JP)**
• **Sakai, Akira**
**Nagahama-shi, Shiga-ken, (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 228 910** **EP-A- 0 234 094**
**EP-A- 0 244 081** **US-A- 4 052 782**

• **PATENT ABSTRACTS OF JAPAN, vol. 10, no. 99**
**(E-396)[2156], 16th April 1986; & JP-A-60 241 222**
• **PATENT ABSTRACTS OF JAPAN, vol. 8, no. 172**
**(C-237)[1609], 9th August 1984; & JP-A-59 69 495**
• **BRITISH JOURNAL OF APPLIED PHYSICS, vol.**
**18, no. 10, October 1967, pages 1357-1382; J.D.**
**FILBY et al.: "Single-crystal films of silicon on**
**insulators"**

## Description

This invention relates to a method as claimed in the precharacterising part of claim 1. Such a method is disclosed in a second embodiment of US-A-3620833. The applicants do not admit that the method of the first embodiment described in that reference can be reproduced or that the indicated results can be reliably obtained.

The present invention can be used to form a crystalline deposited film which may be a single crystal film or a polycrystalline film and which may be used in electronic devices, optical devices, magnetic devices, piezoelectric devices or surface acoustic devices etc. Such devices may include semiconductor integrated circuits, optical integrated circuits, magnetic circuits etc.

In the prior art, single crystal films to be used for semiconductor electronic devices or optical devices have been formed by epitaxial growth on a single crystal substrate. For example, it has been known that epitaxial growth of Si, Ge, GaAs, etc can be carried out from the liquid phase, from the gas phase, or from the solid phase on a Si single crystal substrate (silicon wafer). It is also known that epitaxial growth of a single crystal such as GaAs, GaAlAS etc occurs on a GaAs single crystal substrate. Using a semiconductor thin film formed in this way, semiconductor devices and integrated circuits, and electroluminescent devices such as semiconductor lasers or LEDS have been prepared.

Recently extensive research has been carried out concerning ultra high speed transistors using a two-dimensional electronic gas, and concerning ultra-lattice devices using a quantum well etc. These devices have been made possible by high precision epitaxial techniques such as MBE (molecular beam epitaxy) or MOCVD (organometallic chemical vapour deposition) using an ultra-high vacuum.

In epitaxial growth on a single crystal substrate, it is necessary to match the lattice constants and coefficients of thermal expansion between the single crystal material of the substrate and the epitaxial growth layer. For example, it is possible to effect epitaxial growth of Si single crystal thin film on sapphire which is an insulating single crystal substrate. However, crystal lattice defects at the interface due to differences in lattice constants and diffusion of aluminium which is a component of sapphire into the epitaxial layer pose problems in the application of this process to electronic devices or circuits. Furthermore, the formation of a single crystal thin film by epitaxial growth is highly dependent upon the material of the substrate used.

Mathews et al have discussed combinations of subject material and epitaxial growth layer (Epitaxial Growth, Academic Press, New York 1975, ed. by J. W. Mathews). Only an extremely narrow range of materials are suitable for use as the substrate in the methods of the prior art. Wafers of Si are available in sizes of about 15cm (6 inches) and GaAs substrates are available in lesser sizes. Furthermore the need to use a single crystal substrate increases production cost and hence the cost per chip.

Extensive research has also been carried out in recent years concerning three-dimensional integrated circuits in which semiconductor devices extending in the normal direction of the substrate are laminated one on the other to increase the degree of integration and to provide multi-functionality. Research has also been carried out concerning large area semiconductor devices in which individual devices are arranged in an array on an inexpensive glass substrate. Such devices are becoming more abundant from year to year and examples include solar batteries and switching transistors of liquid crystal picture elements.

A common feature of both of these techniques is the need to provide a semiconductor thin film on an amorphous insulating material and subsequently form electronic devices such as transistors etc thereon. There is, in particular, a requirement to be able to form a single crystal semiconductor of high quality on an amorphous insulating material.

Generally speaking, when a thin film is deposited on a substrate which is an amorphous insulating material such as $SiO_2$ etc, the deposited film has an amorphous or polycrystalline structure due to defects in the long distance order of the substrate material. An amorphous film is in a state in which local order between the closest atoms is preserved, but no longer distance order exists. In a polycrystalline film single crystal grains are present but, as is apparent from the boundaries which separate the grains, there is no specific crystal direction. For example, in the case of forming Si on $SiO_2$ by the CVD method, if the deposition temperature is about 600°C or lower the product film is of amorphous silicon while polycrystalline silicon with a distribution of grain sizes between some hundred and some thousand Å (1Å = 0.1 nm) is formed above that temperature. The grain sizes of the polycrystalline silicon and the distribution thereof vary greatly depending upon the method of formation of the silicon. Furthermore, by melting and solidifying an amorphous or polycrystalline film by a beam of energy e.g. from a laser or a rod-shaped heater etc a polycrystalline thin film has been obtained whose grain size is some microns or millimetres (Single Crystal. Silicon on Non-Single Crystal Insulator, Journal of Crystal Growth, Vol 63, No 3, October 1983 edited by G. W. Cullen).

When a transistor is formed on a thin film made by the methods described above and having the resulting crystal structures and the electron mobility is measured, a mobility of about 0.1 $cm^2$/V.sec or less is obtained for amorphous silicon, a mobility of 1 to 10 $cm^2$/V.sec for polycrystalline silicon having grain sizes of some 100 Å and a mobility similar to that of single crystalline silicon for polycrystalline silicon which has been melted and solidified to produce large grain sizes. From these results it can be understood that there is a great difference in electrical properties between a device formed in a single crystal region within a crystal grain and device formed so as to bridge across a grain boundary. In other words, the deposited film on the amorphous material obtained in the prior art has an amorphous or polycrystalline structure in which there is a distribution of grain sizes, and devices formed thereon have greatly inferior performance compared with the devices prepared on a single crystal layer. For this reason, films deposited on polycrystalline or amorphous material can only be used to make simple switching devices, solar batteries, photoelectric converting devices, etc.

On the other hand, the method in which melting and solidification are used to form polycrystalline thin film of large grain size suffers from the problems that an enormous process time is required due to the need to scan the amorphous or single crystal thin film of every wafer with an energy beam, which gives poor productivity and also that the method is unsuitable for the treatment of large areas.

Furthermore in recent years studies of diamond thin film growth have become popular. Diamond thin film is a semiconductor having the particularly broad band gap of 5.5 eV and has a higher working temperature (about 500°C or less) than Si, Ge, GaAs etc which are established semiconductor materials. Also, the carrier mobility of both electrons and positive holes surpasses that of Si (1800cm$^2$/V.sec for electrons, 1600cm$^2$/V.sec for positive holes) and thermal conductivity is also extremely high. For this reason diamond thin film is considered to be a promising material for high power semiconductor devices in which large quantities of heat are generated. However, although there have been reports in the prior art about epitaxial growth of diamond thin film on a diamond substrate by vapour phase growth (N. Fujimoto, T. Imai and A. Doi, Pro. of Int. Conf. IPAT), there has been no successful report about heteroepitaxial growth on a substrate other than an diamond substrate.

Generally speaking, diamond nuclei are generated using excitation with microwaves using a hydrocarbon type gas such as $CH_4$ etc and by irradiation with a hot filament or electron beam. However, the nucleation density is generally low so that it is difficult to obtain a continuous thin film. Even where a continuous film is formed, it has a polycrystalline structure with a large grain size distribution and it is difficult to use in semiconductor devices. Also if a diamond structure is required, the substrate is self-evidently expensive which also presents problems in enlarging the area of the film which can be produced. Therefore the use of diamond substrates is impractical.

It is apparent from the foregoing that there has been up to now no practical, easy and inexpensive way of making single crystal and polycrystal films on which devices of good electrical characteristics can be formed and which permits greater film areas or three-dimensional integration.

For the formation of functional films, and in particular crystalline semiconductor films, products requiring particular physical characteristics or intended for particular uses have been made by individual film forming methods. One example is the formation of films of amorphous or polycrystalline silicon i.e. non-single crystalline silicon. Such films may optionally be compensated for lone pair electrons with a compensating agent such as hydrogen atoms (H) or halogen atoms (X), etc. These films are hereinafter referred to as "non-Si (HX)" particularly "A-Si (HX)" when indicating amorphous silicon and "poly-Si (HX)" when indicating polycrystalline silicon. The so called micro-crystalline silicon is, of course, included within the category of A-Si (HX). Forming methods which have been employed include vacuum vapour deposition, plasma CVD, thermal CVD, reactive sputtering, ion plating and optical CVD. Generally the plasma CVD method has been widely used and industrialised.

The reaction process required to form a silicon deposited film by the plasma CVD method which has been generally used in the prior art is considerably more complicated than conventional CVD, and its reaction mechanism is not completely understood. Also there exist a large number of parameters for formation of a deposited film such as substrate temperature, flow rate and flow rate ratio of the gases to be introduced, pressure during formation, high frequency power, electrode structure, structure of the reaction vessel, speed of evacuation, plasma generating system etc. Because of these large numbers of parameters which have, in combination, to be selected, the plasma may sometimes become unstable which has a marked deleterious influence on the deposited film formed. Furthermore the parameters required for film forming must be selected individually for each device and therefore with the present knowledge it has been difficult to generalise the production conditions. The plasma CVD method suffers from the further drawback that since plasma is directly generated by high frequency or microwaves etc in a film forming space in which a substrate on which film is to be formed is placed, electrons or various ionic species are generated which can damage the film as it is formed, resulting in reduced film quality or non-uniformity of the film produced. Moreover a crystalline film is deposited only over a restricted range of conditions so that it is difficult to produce polycrystalline deposited film with reproducible characteristics.

On the other hand, for formation of an epitaxial deposited film, for example of silicon, germanium, group II-IV or Group III-V semiconductors. etc, there has been used gas phase epitaxy and liquid phase epitaxy as broadly defined. Generally speaking the strict definition of epitaxy is the growth of another single crystal on one single crystal, both having the same crystal axis. However, here epitaxy is interpreted in a broader sense and is not limited to growth onto a single crystal substrate.

Liquid phase epitaxy is a method for precipitating a semiconductor crystal on a substrate by dissolving a semiconductor starting material at high temperatures in a molten solvent metal and cooling the solution to a super-saturated state. In this method, since crystals are grown under conditions closest to thermal equilibrium among the various epitaxy techniques, crystals with a high degree of perfection can be obtained. However, bulk productivity is poor and the surface state is bad. For these reasons, in an optical device which requires an epitaxial layer which is thin and also of uniform thickness, problems arise such as yield in device production, or influences exerted on device characteristics etc and therefore this method is not frequently used.

Gas phase epitaxy has been attempted by physical methods such as vacuum vapour deposition methods and sputtering methods etc, or chemical methods such as hydrogen reduction of a metal chloride or thermal pyrolysis of a metal organic compound or a metal hydride. Amongst these methods, molecular beam epitaxy which is a dry process involving vacuum vapour deposition under ultra-high vacuum conditions, and therefore gives a high purity product at low temperatures, can be used. It has the advantage that the composition and concentration of the product film can be well controlled and a relatively flat deposited film can be obtained. However, in addition to the enormous cost required for a suitable film forming device, the product films suffer from high surface defect density, and no effective method for controlling the directionality of the molecular beam has been developed. Furthermore, it difficult to produce films of large area, and the bulk productivity is not so high. Due to these various problems, the method has not been industrialised yet.

The hydrogen reduction method using a metal chloride, or the thermal pyrolysis method using a metal organic compound or a metal hydride are generally referred to as the halide CVD method, the hydride CVD method and the MOCVD method. These methods have been extensively studied because a suitable film forming device can be made with relative ease and also because the starting materials i.e. metal chloride, metal hydrides and organic metal compounds are now readily available with high purity. However, in these methods it is necessary to heat the substrate to a high temperature at which the reduction reaction or thermal pyrolysis reaction can take place and therefore the range of substrate materials which can be used is limited. Furthermore, contamination with impurities such as carbon or halogen etc can arise if decomposition of the starting materials is insufficient, thus giving rise to the drawback that controllability of doping is poor. Furthermore, no technique yet exists which enables mass production to be carried out while maintaining the characteristics required for practical use. These characteristics may include a sufficiently large area, a sufficient uniformity of film thickness, a sufficient uniformity of film quality and the ability to produce the films at high speed.

JP-A-6024122 discloses a method for depositing amorphous silicon by introducing a gaseous starting material in the form of a straight chain silane compound and a gaseous halogen oxidising agent into a reaction chamber containing a substrate.

## SUMMARY OF THE INVENTION

One object of the invention is to provide a method for forming a crystalline deposited film which can overcome some or all of the problems of the prior art as described above.

Another object of the present invention is to provide a method for forming a crystalline film of good quality such as a single crystal containing no grain boundary or a polycrystalline film the locations of whose grain boundaries are controlled, without restriction with regard to the base materials used. In particular, it is desirable to avoid restriction with respect to the material, the composition and the size of the substrate.

A further object of the invention is to provide a method for forming a crystalline film with good efficiency using simple steps and without the need for complex apparatus.

A yet further object of the invention is to provide a method for forming a deposited film in which the quality of the film produced is easy to control, the process is economical in use of energy, the product can be a crystalline film having uniform desired characteristics over a wide area and exhibits good semiconductor characteristics.

A further object of the present invention is to provide a method for forming a deposited film which can be carried out rapidly and used for mass production and can form simply and efficiently a crystalline deposited film of high quality and good physical characteristics e.g. electrical, optical or semiconductive characteristics.

A further object of the present invention is to provide a method for forming a deposited film which can be carried out rapidly and used for mass production and which can form simply and efficiently a crystalline deposited film of high quality and good physical characteristics e.g. electrical, optical or semiconductive characteristics.

A further object of the present invention is to provide a further development of the process disclosed in EP-A-0244081 in which the crystal deposition and growth reaction can be carried out with a wider range of substrate materials and without the need to heat the substrate to the high temperatures required for reduction or thermal pyrolysis in the CVD methods disclosed in that application.

The above technical problems are solved according to the invention by the method claimed in claim 1.

## BRIEF DESCRIPTION OF THE DRAWINGS

Fig. 1 is a graph for illustration of the relationship between the size of nucleus rc and free energy G in the process of forming thin film;

Figs. 2(A) and 2(B) are illustrations of the selective deposition method;

Fig. 3 is a graph showing the change with lapse of time of nucleation density (ND) on the deposition surface of $SiO_2$ and the deposition surface of silicon nitride;

Figs. 4(A) to 4(D) are illustrations of the formation steps showing a first embodiment of the method for forming crystal according to the present invention;

Figs. 5(A) and 5(B) are perspective views of the substrate in Figs. 4(A) and 4(D);

Figs. 6(A) to 6(D) are illustrations of the steps for forming crystal showing a second embodiment of the present invention;

Figs. 7(A) to 7(D) are illustrations of the formation steps showing a third embodiment of the method for forming single crystal according to the present invention;

Figs. 8(A) and 8(B) are perspective views of the substrates in Figs. 7(A) and 7( D);

Figs. 9(A) to 9(D) are illustrations of the steps for forming crystal showing a fourth embodiment of the present invention;

Figs. 10(A) to 10(C) are illustrations of formation steps showing a fifth embodiment of the method for forming crystal according to the present invention;

Figs. 11(A) and 11(B) are perspective views of the substrates in Figs. 10(A) to 10(C);

Figs. 12(A) to 12(C) are illustrations of the formation steps of crystal showing a sixth embodiment of the present invention;

Figs. 13(A) to 13(C) are illustrations of the formation steps of crystal showing a seventh embodiment of the present invention;

Fig. 14 is a schematic sectional view showing an example of the multi-layer structure by use of the first embodiment of the present invention;

Figs. 15(A) to 15(D) are illustrations of the steps for forming crystal showing an eighth embodiment of the present invention;

Fig. 16 is a graph showing the relationship between the flow rate of $SiH_4$ and $NH_3$ and the composition ratio of Si and N in the silicon nitride film formed;

Fig. 17 is a graph showing the relationship between Si/N composition ratio and nucleation density;

Fig. 18 is a graph showing the relationship between the injected amount of Si ions and nucleations density;

Figs. 19(A) to 19(D) are illustrations of the formation steps showing a ninth embodiment of the method for forming crystal according to the present invention;

Figs. 20(A) and 20(B) are perspective views of the substrate in Figs. 19(A) and 19(D);

Figs. 21(A) to 21(D) are illustrations of the steps for forming crystal showing a tenth embodiment of the present invention;

Figs. 22(A) to 22(D) are illustrations of the formation steps showing a eleventh embodiment of the method for forming single crystal according to the present invention;

Figs. 23(A) and 23(B) are perspective views of the substrates in Figs. 22(A) and 22(D)

Figs. 24(A) to 24(C) are illustrations of the steps for forming crystal showing a twelfth embodiment of the present invention;

Figs. 25(A) and 25(B) are pespective views of the substrates in Figs. 24(A) and 24(C);

Figs. 26(A) to 26(D) are illustrations of the formation steps of crystal showing a thirteenth embodiment of the present invention;

Fig. 27 is a schematic illustration of the film-forming device used in Examples of the present invention;

Figs. 28(A) to 28(F) are diagrams of the film forming steps according to the present invnetion; and

Figs. 29(A) to 29(E) are diagrams of another film forming steps according to the present invention.

## DESCRIPTION OF THE PREFERRED EMBODIMENT

The method for forming a deposited film of the present invention having the above constitution has one specific feature in forming a deposited film by use of a gaseous halogen oxidizing agent without utilizing plasma reaction while the plasma CVD method of the prior art forms plasma discharging by permitting discharging energy, etc., to act on starting gases for formation of a deposited film, and therefore, the present method is not subjected to any bad influence by etching or abnormal discharging, etc., during film formation will not be raised.

Also, the method for forming a deposited film of the present invention utilizes the redox reaction of a gaseous starting material which becomes the constituent elements of the deposited film with a gaseous halogen oxidizing agent and requires no high temperature for deposition, and therefore there is no disturbance of structure by heat, and no heating installation during production and no expense accompanied with running thereof are required, whereby a device can be made lower in cost. And, it becomes possible to select the substrate material from a wide scope of materials without depending on heat resistance.

Also, the method for forming a deposited film of the present invention forms a deposited film according to the reaction between a gaseous starting material and a gaseous halogen oxidizing agent which progresses as concerned with the adsorbed molecules, and therefore enlargement of area is facilitated not depending on the shape and the size of the substrate, and at the same time starting materials employed may be very small in amounts, whereby the film forming space can be made smaller to improve dramatically the yield.

Also, the method for forming a deposited film of the present invention can determine the sizes of crystal grains by arranging nuclei for crystal growth as desired on a substrate, whereby a crystalline deposited film having the characteristics suited for the purpose can be deposited at any desired region.

Also, according to the method for forming a deposited film of the present invention having the constitution as described above, energy during formation of deposited film can be saved and at the same time control of film quality can be easily practiced, whereby it becomes possible to form a good crystalline deposited film having uniform film quality and characteristics over a large area. Further, it is possible to obtain efficiently a crystalline film which is excellent in productivity and bulk productivity, of high quality and also excellent in various characteristics such as electrical, optical, semiconductive characteristics, etc.

In the method for forming a deposited film of the present invention, the gaseous starting material to be used for formation of a deposited film (hereinafter called "gaseous starting material (I)") is a material to be subjected to oxidation action through contact with the gaseous halogen oxidizing agent (hereinafter called "halogen oxidizing agent (II)"), and may be selected suitably as desired depending on the kind, characteristic, use, etc., of a deposited film to be desired.

In the method of the present invention, the above gaseous starting material (I) and the halogen oxidizing agent (II) have only to be gaseous when introduced, and may be gaseous, liquid or solid under an ordinary state. In the case when the gaseous starting material (I) or the halogen oxidizing agent (II) is liquid or solid under an ordinary state, a carrier gas such as Ar, He, $N_2$, $H_2$, etc., is used to effect bubbling, optionally with heating, and thereby introduce in a gaseous state into a film forming space.

The gaseous starting material and the gaseous halogen oxidizing agent having the property of oxidative action on said starting material introduced into the film forming space contact chemically with each other, whereby a plurality of precursors containing precursors under excited state are formed and at least one precursor of these precursors is used as the source for feeding the constituent element of the deposited film to effect formation of a deposited film (such film forming method is hereinafter called "FOCVD").

During this operation, the introducing pressure of the above gaseous starting material (I) or the halogen oxidizing agent (II) may be set by controlling the flow rate of the carrier gas or the vapor pressure of the gaseous starting material (I) or the halogen oxidizing agnet (II). When the gaseous starting material (I) or the halogen oxidizing agnet (II) is a gas under an ordinary state, it can be also introduced as diluted with a carrier gas such as Ar, He, $N_2$, $H_2$, etc., if necessary.

As the gaseous starting material (I) to be used in the method of the present invention, for obtaining a deposited film of e.g. silicon belonging to the group IV of the periodic table, there may be employed straight and branched chain silane compounds, cyclic silane compounds, etc., as effective ones.

Specifically as the gaseous starting material (I), examples of the straight chain silane compounds may include $Si_nH_{2n+2}$ ($\underline{n}$ = 1, 2, 3, 4, 5, 6, 7 or 8), examples of the branched chain silane compounds $SiH_3SiH(SiH_3)SiH_2SiH_3$, and examples of cyclic silane compounds $Si_nH_{2n}$ ($\underline{n}$ = 3, 4, 5 or 6), etc.

Of course, these silicon compounds may be used in the method of the present invention is made gaseous when introduced into a film forming space and at the same time has the property of exerting oxidation action effectively on the gaseous starting material (I) for formation of a deposited film only through contact therewith, and halogen gases such as $F_2$, $Cl_2$, $Br_2$, $I_2$, ClF, etc., may be employed as effective ones.

Either one of these gaseous starting material (I) and halogen oxidizing agent (II) are introduced in a gaseous state at a desired flow rate and feeding pressure into a film forming space in which a substrate for formation of a deposited film is arranged. The both are collided against each other to cause a chemical reaction, whereby the above halogen oxidizing agent (II) exerts oxidation reaction on the above gaseous starting material (I) to form a material which becomes the crystal nuclei for a deposited film to be formed. Only a single nucleus is selectively formed on a nucleation surface given on the substrate surface and it is possible that the nucleus grows to form a single crystalline deposited film on the substrate. Also, it is possible to obtain easily polycrystalline deposited film in which single crystals are adjacent each other. Such deposited film forming process of the present invention can proceed with higher efficiency and energy saving degree, whereby a crystalline deposited film having desired good physical characteristics over the whole film surface can be formed at a lower substrate temperature than in the prior art.

In the method of the present invention, so that the deposited film forming process may proceed smoothly and a film having desired physical characteristics of high quality may be formed, as film forming factors, kinds and combination of the starting material for formation of a deposited film (I) and the halogen oxidizing agent (II), pressure during reaction, flow rate, inner pressure of the film forming space, kind of the substrate, and film forming temperature (substrate temperature and atmosphere temperature) may be selected suitably as desired. These film forming factors are related organically, and they are not determined individually but determined respectively under mutual relationships. In the method of the present invention, the process of adsorption and reaction of the gaseous starting material (I) for formation of a deposited film and the gaseous halogen oxidizing agent (II) to be introduced into the film forming space may be determined suitably as desired in the relationship with film forming factors concerned among the film forming factors as mentioned above.

The pressures in the formation of a deposited film of the present invention may be set suitably, preferably $1 \times 10^{-7}$ - 10 Torr, more preferably $1 \times 10^{-4}$ - 1 Torr.

In the method of the present invention, for forming selectively a desired crystalline deposited film, it is necessary to arrange previously a material capable of forming selectively crystal nuclei in the form corresponding to the purpose regularly or irregularly scatteringly on the substrate surface.

By utilizing the difference in nuclei formation density of the crystal-forming material according to the kinds of the materials for the formation of crystal-forming surface, by arranging the crystal-forming surface scatteringly with a desired pattern on the substrate, a desired crystalline deposited film can be formed selectively.

For example, a substrate of which silicon single crystals are selectively covered by silicon oxide film and the ground of silicon single crystal is selectively exposed or a substrate which a thin film of silicon nitride with a fine area is selectively arranged on an $SiO_2$ substrate on which growth property of silicon crystal in small may be employed. Further, in place of the silicon crystal as described above, crystal different in kind from silicon may be also used as the nuclei, but the materials of these crystals are required to satisfy the following conditions.

1. The lattice constant of the crystalline material on the substrate surface should be identical with or very approximate to the lattice constant of the deposited film.
2. The coefficients of thermal expansion of the crystalline material on the substrate surface and the deposited film should be identical with or very approximate to each other.

Hence, as the material which should constitute the surface of a suitable substrate for obtaining a deposited film of e.g. crystalline Si, there may be included $GaF_2$, $ZnS$, $Yb$, $Mn_3Ga$, $NaCoF_3$, $Ni_3Sn$, $Fe_3C$, $NiTe_x(\underline{x} < 0.7)$, $CoMnO_3$, $NiMnO_3$, $MaZn_3$, $CuCl$, $AlP$, $Si$, etc.

Further, even when the above two conditions are not fully satisfied, by selecting the deposition conditions more adequately, a crystalline deposited film can be also obtained, and the method for forming a deposited film of the present invention is not limited to the materials only as described above.

As the substrate to be used in order to obtain Si crystal in the present invention, for example, those having $Si_3N_4$ arranged scatteringly on $SiO_2$ film or those having $SiO_2$ covering over $Si_3N_4$ film to have partially the subbing $Si_3N_4$ exposed may be employed.

These substrates utilize the property of silicon crystal nuclei which are formed with ease on $Si_3N_4$ and with difficulty on $SiO_2$, and in the method for forming a deposited film of the present invention, both amorphous and crystalline materials can be used, provided they have difference in difficulty and easiness in formation of nuclei.

The substrate temperature (Ts) during film formation may be set suitably depending on the kind of the deposited film to be formed and the kind of the substrate used.

For better understanding of the present invention, the general process for forming a thin film of metal for semiconductor is explained.

When the deposition surface is made of a material different in kind from the flying atom, particularly an amorphous material, the flying atoms are diffused freely on the substrate surface, or again evaporated (released). And, as the result of collision mutually between the atoms, a nucleus is formed and when its size becomes the size rc ($= -2\sigma_o/gv$) at which its free energy G becomes the maximum (critical nucleus), G is reduced and the nucleus continues to grow stably three-dimensionally to become shaped in an island. The nucleus with the size exceeding rc is called "stable nucleus", and unless otherwise particularly noted, "nucleus" in the following basic description of the present invention refers to this "stable nucleus". Also, among "stable nucleus", those with small $\underline{r}$ are called "initial nucleus".

The free energy generated by formation of nucleus is represented as follows:

$$G = 4\pi f(\theta)(\sigma_o r^2 + 1/3 \cdot gv \cdot r^3)$$

$$f(\theta) = 1/4 (2 - 3\cos\theta + \cos^2\theta)$$

wherein,

r : radius curvature of nucleus
θ : contact angle of nucleus
gv : free energy per unit deposition

$\sigma_o$ :     surface energy between nuclius and vacuum.

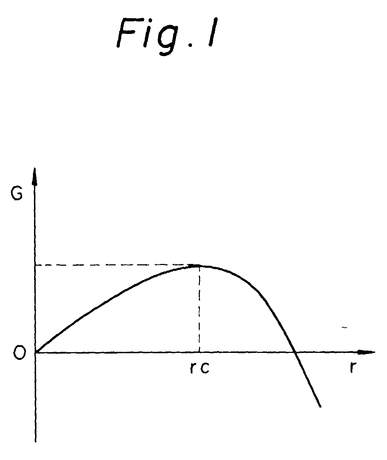

Fig. 1 shows the manner in which free energy G is changed. In the same Figure, the radius of curvature of the stable nucleus when free energy G is at the maximum value is rc.

Thus, nuclei grow to become shaped in islands, and further grow whereby contact mutually between islands progresses until sometimes coalescence occurs and via a network structure, it becomes finally a continuous film to cover completely over the substrate surface. Following such a process, a thin film is deposited on the substrate.

In the deposition process as described above, the density of nucleus formed per unit area of the substrate surface, the size of nucleus and the nucleation speed are determined depending on the state of the system of deposition, and particularly the interaction between the flying atoms and the substrate surface material is an important factor. Also, a specific crystal direction grows in parallel to the substrate due to anisotropy relative to the crystal surface of the interface energy at the interface between the deposited material and the substrate, and when the substrate is amorphous, the crystal direction within the substrate plane is not constant. For this reason, grain boundaries are formed by collision mutually between nuclei or islands, and particularly in the case of collision mutually between islands with some sizes or greater, grain boundaries are formed as such upon occurrence of coalescence. Since the grain boundaries formed are difficultly movable in the solid phase, the grain sizes are determined at that point.

Next, the selective deposition method for forming a deposited film selectively on the deposition surface is to be described. The selective deposition method is a method in which a thin film is formed selectively on the substrate by utilizing the differences between the materials in factors influencing nucleus formation in the thin film forming process such as surface energy, attachment coefficient, release coefficient, surface diffusion speed, etc.

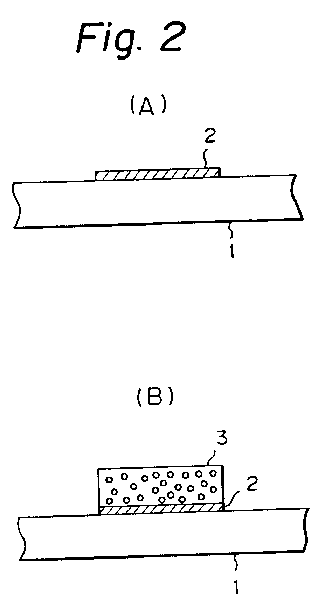

Figs. 2A and 2B are illustrations of the selective deposition method. First, as shown in Figure 2A, on the substrate 1, a thin film 2 comprising a material different in the above factors from the substrate 1 is formed at a desired portion. And, when deposition of a thin film comprising an appropriate material is effected under appropriate deposition conditions, a thin film 3 grows only on the thin film 2, whereby it is possible to give rise to a phenomenon that no growth occurs on the substrate 1. By utilizing this phenomenon, the thin film 3 formed self-matchingly can be grown, whereby it becomes possible to omit the lithographic step by use of a resist as practiced in the prior art.

As the material for enabling deposition according to such selective formation method, for example, $SiO_2$ may be used as the substrate 1, Si, GaAs, silicon nitrode as the thin film 2 and Si, W, GaAs, InP, etc., as the thin film 3 to be deposited.

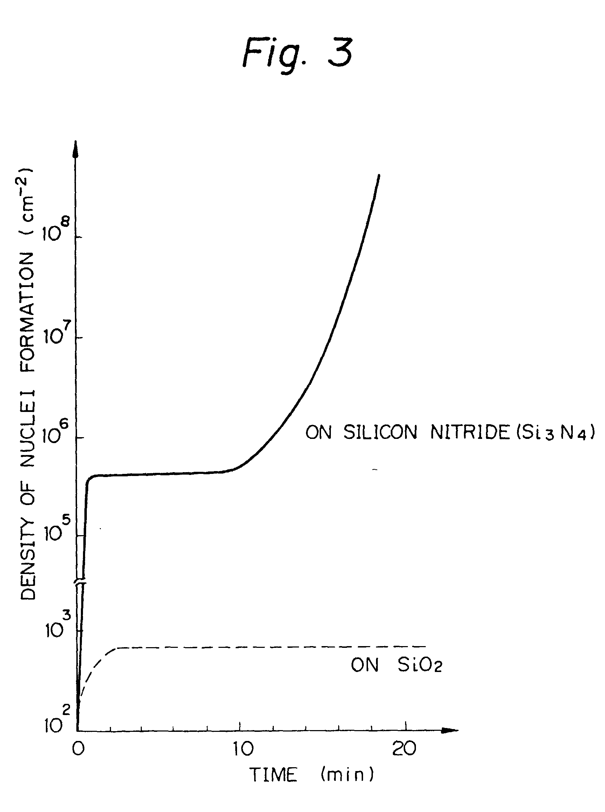

Fig. 3 is a graph showing the change with lapse of time of nucleation density (ND) on the deposited surface of $SiO_2$ and the deposited surface of silicon nitride.

As shown in the same graph, soon after initiation of deposition, the nucleation density (ND) on $SiO_2$ is saturated at $10^3$ cm$^{-2}$ or less, and the value is not substantially changed even after 20 minutes.

In contrast, on silicon nitride ($Si_3N_4$), it is once saturated at about $4 \times 10^5$ cm$^{-2}$ or less is not substantially changed 10 minutes thereafter, but is abruptly increased thereafter. This measurement example shows the case in which $SiCl_4$ gas is diluted with $H_2$ and deposited according to the CVD method under the conditions of a pressure of 170 Torr and a temperature of 1000 °C.

Such a phenomenon depends greatly on the difference in adsorption coefficient, release coefficient, surface diffusion coefficient, etc., relative to Si of the material surfaces of $SiO_2$ and silicon nitride, but the fact that $SiO_2$ itself is etched by the reaction of $SiO_2$ with Si atom itself to form silicon monooxide with higher vapor pressure, while no such etching phenomenon occurs on silicon nitride may be also considered to be a cause to effect selective deposition (T. Yonehara, S. Yoshioka, S. Miyazawa, Journal of Applied Physics 53, 6839, (1982)).

Thus, by selecting $SiO_2$ and silicon nitride as the materials of the deposition surface and silicon as the material to be deposited, sufficiently great nucleation density difference ($\Delta$ND) as shown in the same graph can be obtained. Here, although $SiO_2$ is desirable as the material for the deposition surface, this is not limitative and sufficiently practical nucleation density difference ($\Delta$ND) can be obtained even by use of $SiO_x$ ($0 < x < 2$).

Of course, the present invention is not limited to these materials, but the difference in nucleation density ($\Delta$ND) may be sufficiently $10^3$-fold or more in density of nuclei as shown by the same graph, and sufficient selective formation of deposited film can be done with the materials as exemplified below.

As another method for obtaining this nucleation density difference (ND), ions of Si, N, etc., may be injected locally into the $SiO_2$ surface to form a region having excessive Si or N.

The present invention utilizes selective deposition based on such nucleation density difference ($\Delta$ND) and, by forming a sufficiently minute region of a different kind of material having sufficiently greater nucleation density than the material of the deposition surface, so that a single nucleus may grow on the region, a single crystal is to be grown selectively only at the site where such fine different kind of material exists.

In this connection, since selective growth of a single crystal is determined depending on the electron state of the crystal formation surface, particularly the state of dangling bonds, the material with higher nucleation density (for example, $Si_3N_4$) is not required to be a bulk material, but it may also be formed as a thin film on the surface of base plate of any desired material to form the above crystal formation surface.

In the following, the present invention is described in detail by referring to the drawings.

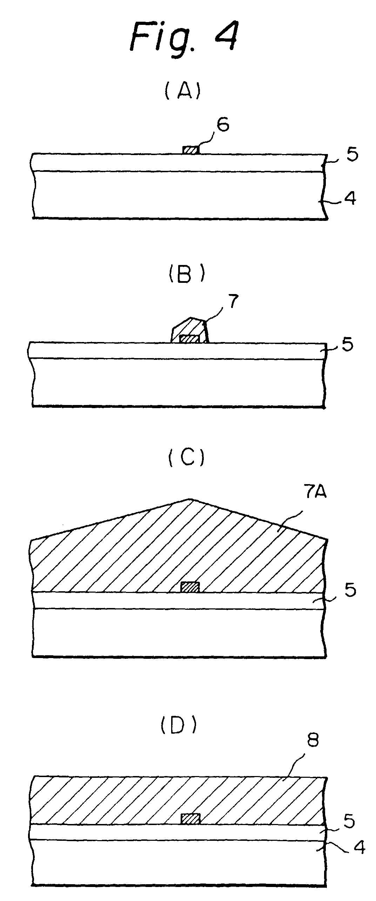

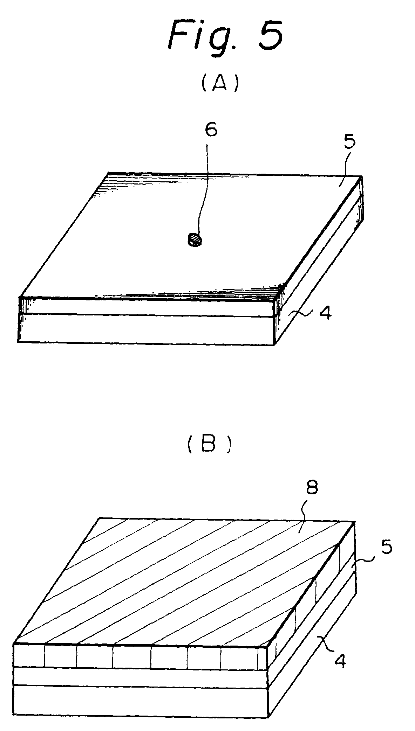

Figs. 4A - 4D are illustrations of the formation steps showing a first embodiment of the method for forming crystal according to the present invention, and Figs. 5A and 5B are perspective views corresponding to Figs. 4A and 4D.

First, as shown in Fig. 4A and Fig. 5A, on the substrate 4, a thin film 5 non-nucleation surface ($S_{NDS}$) with small nucleation density which enables selective deposition is formed and a material different from the material forming the thin film 5 with smaller nucleation density is deposited thinly, followed by patterning according to lithography, etc., to form sufficiently finely nucleation surface 6 ($S_{NDL}$) (or called "Seed") comprising a different kind of material. However, the size, the crystal structure and the composition of the substrate 4 may be any desired ones, and a substrate having a functional device formed thereon prepared according to conventional semiconductor technique may be employed. Also, the nucleation surface ($S_{NDL}$) 6 comprising a different kind of material is also inclusive of modified regions having excessive Si or N formed by ion injection of Si or N into the thin film 5 as described above.

Next, by selection of appropriate deposition conditions according to the FOCVD method, a crystalline deposited film is formed. That is, a single nucleus of a thin film material is firstly formed only on the nucleation surface ($S_{NDL}$) 6. The size of the nucleation surface ($S_{NDL}$) 6, which may differ depending on the kind of the material, may be several microns or less. Further, the nucleus grows while maintaining a single crystal structure to become a single crystal grain 7 in shape of an island as shown in Fig. 4(B). For forming an island-shaped single crystal grain 7, it is desirable to determine the conditions so that no nucleation may occur at all on the thin film 5A, as already mentioned.

The island-shaped single crystal grain 7 further grows while maintaining the single crystal structure with the nucleation surface ($S_{NDL}$) 6 as the center (lateral overgrowth), whereby it can cover over the whole surface of the thin film 5 as shown in the same Figure (C) (single crystal 7A).

Subsequently, if necessary, the single crystal 7A is flattened by etching or polishing, and a single crystal layer 8 capable of forming a desired device can be formed on the thin film 5 as shown in Fig. 4(D) and Fig. 5(B).

Thus, due to formation of the thin film 5 for forming the non-nucleation surface ($S_{NDS}$) on the substrate 4, any desired material can be used for the substrate 4 which is the supporting member. Further, in such a case, even when the substrate 4 may be one having a functional device, etc., formed thereon according to conventional semiconductor technique, the single crystal layer 8 can be easily formed thereon.

In the above embodiment, the non-nucleation surface ($S_{NDS}$) is formed of thin film 5, but a substrate comprising a material with small nucleation density (ND) enabling selective nucleation may be used as such and nucleation surfaces ($S_{NDL}$) may be provided at any desired positions to form single crystal layers similarly thereon.

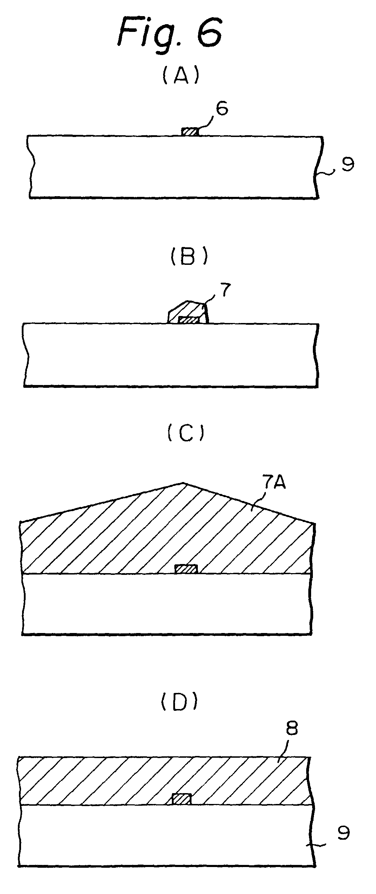

Figs. 6(A) - 6(D) are illustrations of the steps for forming crystal showing a second embodiment of the present invention. As shown in these figures, on a substrate 9 comprising a material with small nucleation density (ND) enabling selective nucleation, the nucleation surface ($S_{NDL}$) comprising a material with great nucleation density (ND) can be formed sufficiently minutely to form a single crystal layer 8 similarly as in the first embodiment.

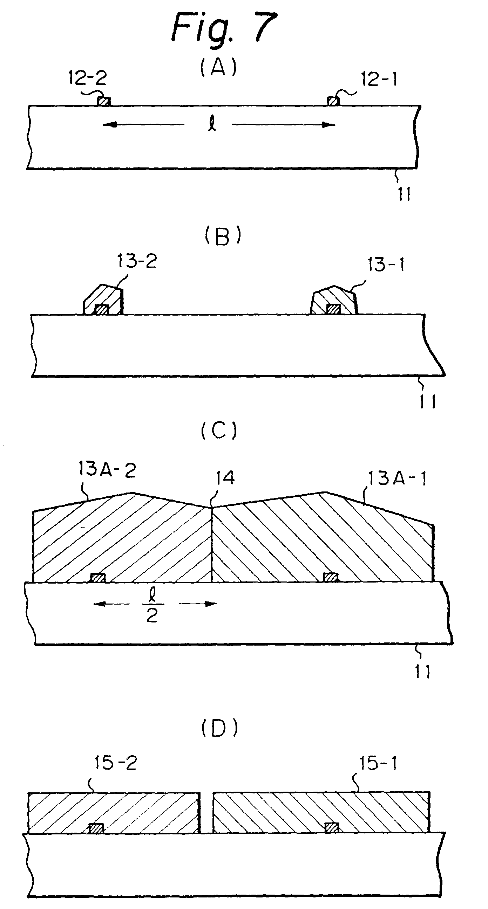

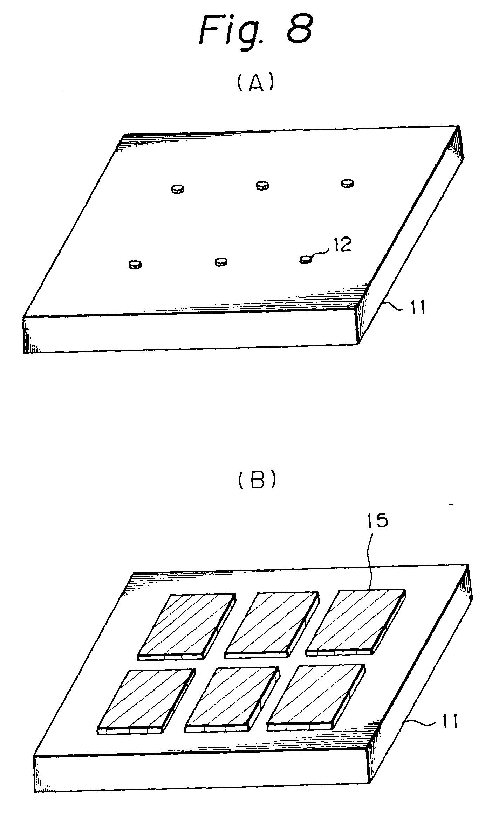

Figs. 7(A) - 7(D) are illustrations of the formation steps showing a third embodiment of the method for forming crystal according to the present invention, and Figs. 8(A) and 8(B) are perspective views corresponding to Figs. 7(A) and 7(D).

As shown in Fig. 7(A) and Fig. 8(A), on the amorphous insulating substrate 11, with an interval of a distance $\ell$, nucleation surfaces ($S_{NDL}$) 12-1, 12-2, of a material different from the substrate 11 enabling the above selective nucleation are arranged sufficiently finely. The distance $\ell$ is set equal to the size of the single crystal region required for formation of semiconductor device or group of devices or greater.

Next, by selecting appropriate crystal forming conditions, on the nucleation surfaces ($S_{NDL}$) 12-1, 12-2, only a nucleus of a crystal forming material is formed. That is, the nucleation surfaces 12-1, 12-2, are required to be formed to a sufficiently fine size (area) to the extent that only a single nucleus may be formed. The size of the nucleation surfaces ($S_{NDL}$) 12-1, 12-2, which may be different depending on the kind of the material, may be several microns or less. Further, the nucleus grows while maintaining the single crystal structure, and become island-shaped single crystal grains 13-1, 13-2, as shown in Fig. 7(B). For forming island-shaped single crystal grains 13-1, 13-2, it is desirable to determine the conditions so that substantially no nucleation may occur at all on other surfaces than the nucleation surfaces ($S_{NDL}$) on the substrate 11.

The crystal direction in the normal line direction of the substrate 11 of the island-shaped single crystal grains 13-1, 13-2 is determined so as to make the interface energy of the material of the substrate 11 and the material forming nucleus minimum. For, surface or interface energy has anisotropy depending on the crystal face. However, as already mentioned, the crystal direction within the substrate plane in amorphous substrate is not determined.

The island-shaped single crystal grains 13-1, 13-2 further grow to become single crystals 13A-1, 13A-2, until the adjacent single crystals 13A-1, 13A-2, contact each other as shown in Fig. 7(C), but since the crystal directions within the substrate plane are not constant, a crystal grain boundary 14 is formed at the intermediate position between the nucleation surfaces ($S_{NDL}$) 12-1 and 12-2.

Subsequently, the single crystals 13A-1, 13A-2 grow three-dimensionally, but crystal faces with slow growth speed appear as the facet. For this reason, the surfaces of single crystals 13A-1, 13A-2 are flattened by etching or polishing, and further the portion of the grain boundary 14 is removed to form thin films of single crystals 15-1, 15-2,... containing no grain boundary in shape of lattices as shown in Fig. 7(D) and Fig. 8(B). The size of the single crystal films 15-1, 15-2, ... is determined by the interval $\underline{1}$ between the nucleation surfaces ($S_{NDL}$) 12A-1, 12A-2, as described above. That is, by determining appropriately the formation pattern of the nucleation surface ($S_{NDL}$) 12A-1, 12A-2, the position of the grain boundary can be controlled to form single crystals with desired sizes at a desired arrangement.

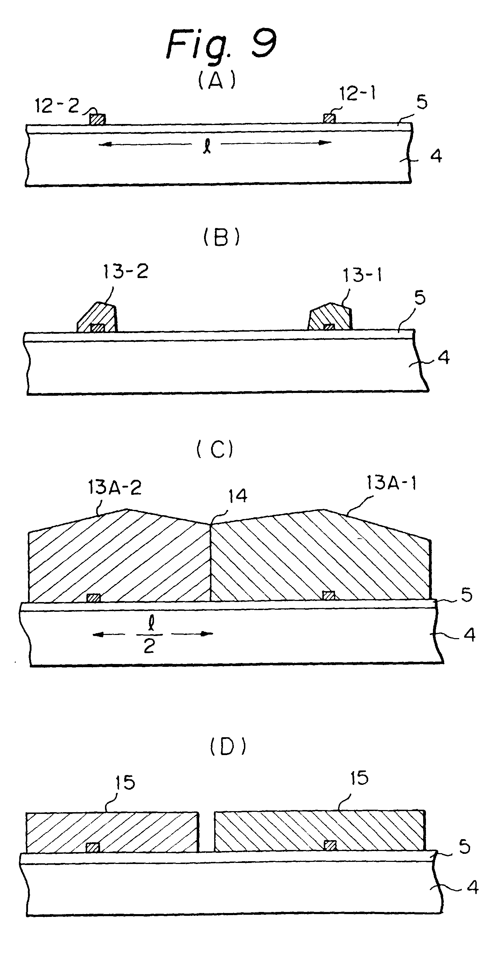

Fig. 9(A)-(D) are illustrations of the formation steps of crystal showing a fourth embodiment of the present invention. As shown in these Figures, similarly as described in the first embodiment, on a desired substrate 4 is formed a thin film non-nucleation surface ($S_{NDS}$)5 comprising a material with small nucleation density (DN) enabling selective nucleation is formed, and nucleation surfaces ($S_{NDL}$)12 comprising a different kind of material with greater nucleation density (ND) are formed with an interval $\underline{\ell}$ thereon, and a single crystal layer 15 can be formed in the same manner as in the above third embodiment.

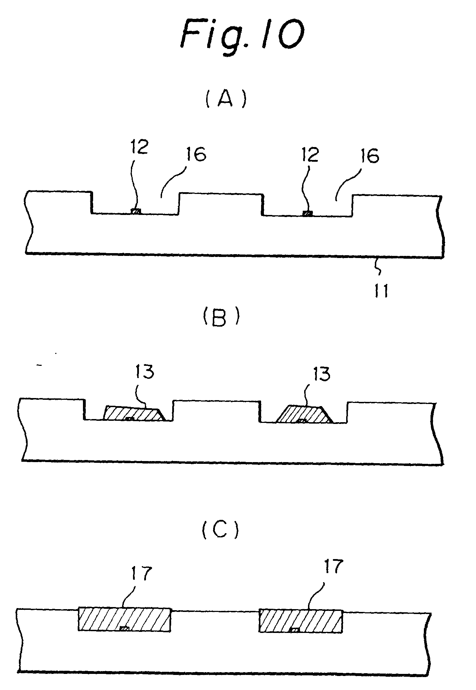

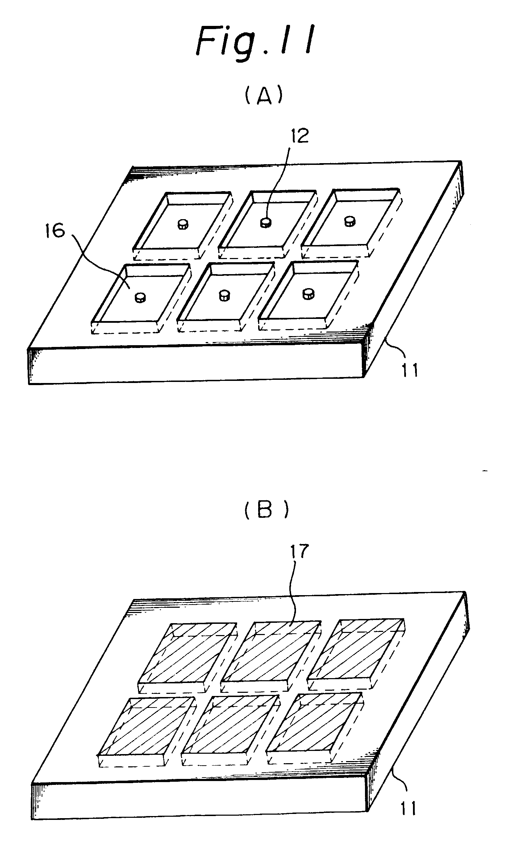

Figs. 10(A) - 10(C) are illustrations of the formation steps showing a fifth embodiment of the method for forming crystal according to the present invention, and Figs. 11(A) and 11(B) are perspective views of the substrates in Figs. 10(A) and 10(C).

First, as shown in Fig. 10(A) and Fig. 11(A), concavities 16 with desired size and shape are formed on the amorphous insulating substrate 11, and nucleation surfaces ($S_{NDL}$) 12 with sufficiently fine size for forming only single nucleus are formed therein.

Subsequently, as shown in Fig. 10(B), island-shaped single crystal grains 13 are grown similarly as in the second embodiment.

And, as shown in Fig. 10(C) and Fig. 11(B), single crystal grains 13 are grown until embedding the concavity 16 to form a single crystal layer 17.

In this embodiment, since single crystal grains 13 grow within the concavity 16, the steps of flattening and removing the grain portion may be unnecessary.

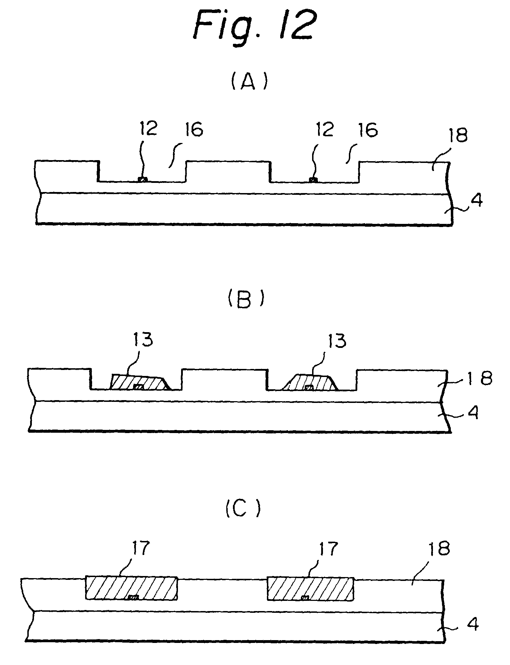

Fig. 12(A)-(C) are illustrations of the formation steps of crystal showing a sixth embodiment of the present invention. As shown in these Figures, on any desired substrate 4 similarly as in the first embodiment, a thin film non-nucleation surface ($S_{NDS}$) 18 comprising a material with small nucleation density(ND) enabling selective nucleation is formed, and concavities 16 with desired size and shape are formed thereon. and, within the concavities are formed minutely nucleation surfaces ($S_{NDL}$)12 comprising a material with greater nucleation density (ND) which is different from the material forming the nonnucleation surface ($S_{NDS}$), and single crystal layers 17 are formed in the same manner as in the fifth embodiment.

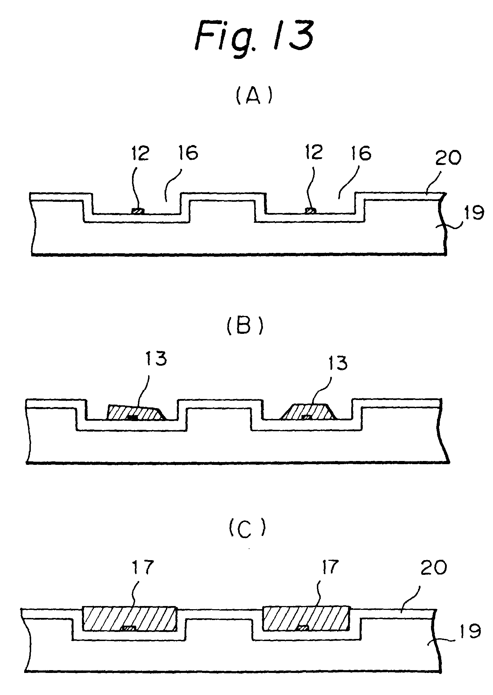

Fig. 13(A)-(C) are illustrations of the formation steps of crystal showing a seventh embodiment of the present invention. After formation of concavities on a desired substrate, a thin film nonnucleation surface ($S_{NDS}$)20 comprising a material with sufficiently small nucleation density (ND) enabling selective nucleation is formed, and following the same procedure as in the above embodiments, single crystal layers 17 can be formed.

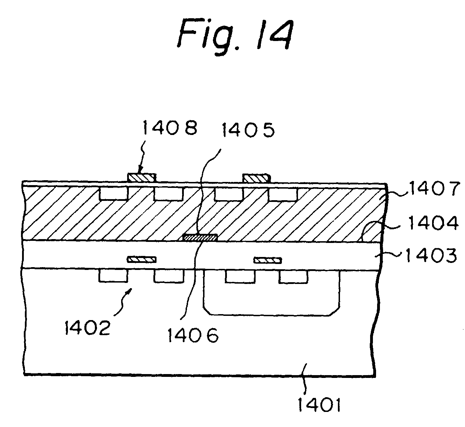

Fig. 14 is a schematic sectional view showing an example of the semiconductor electronic device with a multilayer structure produced by use of the first embodiment of the present invention.

In Fig. 14 on the semiconductor substrate 1401 such as Si or GaAs, transistors 1402 or other semiconductor devices or optical devices are formed, and $SiO_2$ layer 1403 having a surface for formation of, for example, non-nucleation surface ($S_{NDS}$) 1404 is formed thereon according to the CVD method or the sputtering method. And, as already mentioned, a thin film 1406 having nucleation surfaces ($S_{NDL}$) 1405 having sufficiently minute areas so that only a single nucleus are formed of, for example, $Si_3N_4$, and a single crystal is grown from said nucleation surface ($S_{NDL}$) 1405 to form an Si single crystal layer 1407.

Subsequently, on the single crystal layer 1407 are formed transistors 1408 or other semiconductor devices or optical devices, and the devices formed respectively on the substrate 1401 and the Si single crystal layer 1407 are electrically connected through the $SiO_2$ layer 1403. Thus, for example, by forming the transistor 1402 of the first layer (substrate 1401) and the transistor 1408 of the second layer (single crystal layer 1404) respectively as the MOS transistors, and connecting these to form CMOS, a CMOS entirely free from mutual interaction can be produced. Also, according to the technique as described above, an electroluminescent device can be also formed integrated with its driving circuit to accomplish a high degree of integration.

Further, by repeating this embodiment, single crystal layers 1407 can be formed in many layers with $SiO_2$ layer 1403 sandwiched therebetween, whereby a semiconductor electronic device with a multiple structure can be formed easily.

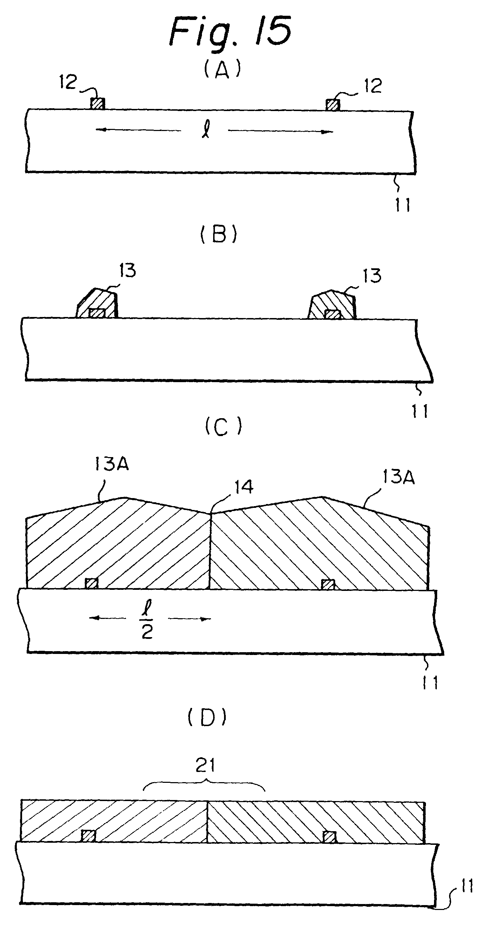

Figs. 15(A)-15(D) are illustrations of the steps for forming crystal showing an eighth embodiment of the present invention.

Figs. 15(A)-15(C) are the same as Figs. 7(A) - 7(C). That is, a plurality (two in the figure) of nucleation surfaces 12 are formed with an interval of $\underline{\ell}$, and single crystal grains 13 subjected to overgrowth on the nucleation surfaces 12 are formed. By permitting the single crystal grains 13 to further grow to form single crystals 13A, a grain boundary 14 is formed approximately at the center between the nucleation surfaces ($S_{NDL}$) 12, and by flattening the surface of single crystal 13A, a polycrystalline layer 21 with regular grain sizes which are approximately equal to $\ell$ as shown in Fig. 15 (D) can be obtained.

Since the grain size of the polycrystalline layer 21 is determined by the interval $\ell$ between the nucleation surfaces ($S_{NDL}$) 12, it becomes possible to control the grain size of the polycrystal. In the prior art, the grain size of a polycrystal was changed by a plural number of factors such as the formation method, formation temperature, etc., and also when preparing a polycrystal with large grain size, it had a grain size distribution with a considerable width. However, according to the present invention, the grain size and grain size distribution can be determined with good controllability by the interval $\ell$ between the nucleation surfaces 12.

Of course, as shown in Fig. 9, the above polycrystal layer 21 may be formed by forming a non-nucleation surface ($S_{NDS}$) 5 with small nucleation density (ND) on a desired substrate 4 and nucleation surfaces ($S_{NDL}$) 12-1, 12-2 with greater nucleation density (ND). In this case, as already mentioned, the substrate material and structure are not limited, but the polycrystal layer 21 can be formed by controlling the grain size and the grain size distribution.

Next, the specific method for forming a single crystal layer or a polycrystal layer in the above respective embodiments is described in more detail by referring primarily to the third embodiment shown in Fig. 7 and the eighth embodiment shown in Fig. 15.

By thermal oxidation of an Si single crystal wafer to form an $SiO_2$ layer on the surface, a substrate 11 is obtained with its surface being formed into non-nucleation surface ($S_{NDS}$). Of course, a quartz substrate which is a material with small nucleation density (ND) can be also used as the substrate 11, or alternatively non-nucleation surface ($S_{NDS}$) may be provided by forming $SiO_2$ layer on the surface of any desired base substrate such as metal, semiconductor, magnetic material, piezoelectric material, insulator, etc., by use of the sputtering method, the CVD method, the vacuum vapor deposition method, etc. Also, as the material forming non-nucleation surfaces ($S_{NDS}$), $SiO_2$ is desirable, but $SiO_x$ (0<x<1) with the value of $x$ being varied may be also employed.

On the $SiO_2$ layer of the substrate 11 having $SiO_2$ layer thus formed on the surface is deposited as silicon nitride layer (e.g. $Si_3N_4$ layer) or a polycrystalline silicon layer according to the reduced pressure chemical vapor deposition method, and subsequently the silicon nitride layer or polycrystalline silicon layer is subjected to patterning according to conventional lithographic technique or lithographic technique by use of X-ray, electron beam or ion beam, whereby nucleation surface ($S_{NDL}$) 12 having fine area of preferably 10 μm or less, more preferably several micron or less, optimally about 1 μm or less.

Subsequently, for example, by the selective use of a suitable gas among the abovementioned gases and according to the FOCVD method, for example an Si single crystal is selectively grown on the above substrate 11. In this procedure, the substrate temperature, pressure, etc., may be conveniently determined, but the substrate temperature may be preferably 100 to 600 °C.

Within a time of about some 10 minutes, by selection of optimum growth conditions, grains 13 of single crystals of Si grow on the nucleation surfaces ($S_{NDS}$) 12 comprising silicon nitride layer or polycrystalline silicon layer on the $SiO_2$ layer as the center, and grow to sizes of some 10 μm or more.

Subsequently, by the reactive ion etching (RIE) method utilizing the etching speed difference between Si and $SiO_2$, the surfaces of the single crystals 13A are flattened by selective etching of only Si, whereby a polycrystalline silicon layer 21 controlled in grain size can be formed (Fig. 15(D)). Further, by removing the grain boundary portion, island-shaped single crystalline silicon layers 15-1, 15-2 are formed (Fig. 7(D)). If unevenness on the surface of the single crystal grains 13A-1, 13A-2 are large, mechanical polishing may be conducted before etching.

When electrical field effect transistors are formed according to conventional semiconductor device preparation technique on the single crystal silicon layers 15 thus formed with a size of some 10 μm or more containing no grain boundary, characteristics not inferior to that formed on single silicon wafer are exhibited.

Also, mutual interference between the adjacent single crystal silicon layers can be prevented, if they are electrically separated by an electrical insulator such as $SiO_2$, even if a complementary type electrical field effect transistor (C-MOS) may be constituted.

Also, since the thickness of the active layer of the device formed is thinner than the case when employing Si wafer, there is no erroneous actuation by the charges generated when radiation is irradiated. Further, due to lowering in unwanted capacity, speed-up of the device can be effected. Also, since any desired substrate can be used, a single crystal layer can be formed on a substrate of large area at lower cost than when employing Si wafer. Further, since a single crystal layer can be formed also on other semiconductors, piezoelectric materials, dielectric materials, etc., a multi-functional three-dimensional integrated circuit can be realized. Thus, the present invention exhibits a number of excellent effects.

(Composition of silicon nitride)

For obtaining sufficient nucleation density difference (ΔND) between the material ($M_S$) for formation of non-nucleation surface ($S_{NDS}$) and the material ($M_L$) for formation of nucleation surface ($S_{NDL}$) as described above, for polycrystalline silicon or $SiO_2$ as the material for formation of non-nucleation surface ($S_{NDS}$) to be used in combination, the material for formation of nucleation surface ($S_{NDL}$) is not limited to $Si_3N_4$, but silicon nitrides with various chemical composition ratios may be employed.

The chemical composition ratio of silicon nitride may be varied e.g. as follows.

In the plasma CVD method for forming silicon nitride film at low temperature by decomposition of $SiH_4$ gas and $NH_3$ gas in RF plasma, by varying the flow rate ratio of $SiH_4$ gas and $NH_3$ gas, the composition ratio of Si and N in the deposited silicon nitride film can be varied to a great extent.

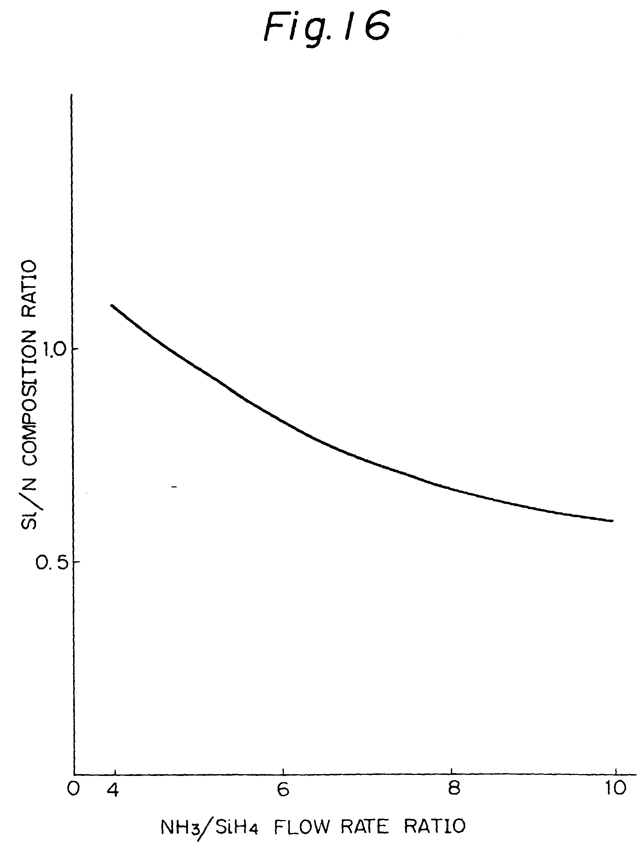

Fig. 16 is a graph showing an example of the relationship between the flow rate ratio of $SiH_4$ and $NH_3$ and the composition ratio of Si and N in the silicon nitride film formed.

The deposition conditions at this time were RF output of 175 W, substrate temperature of 380 °C and the flow rate of $NH_3$ gas was varied with the $SiH_4$ gas flow rate being fixed at 300 cc/min. As shown in the same graph, by varying the gas flow rate ratio of $NH_3/SiH_4$ from 4 to 10, the Si/N ratio in the silicon nitride film was found to be varied from 1.1 to 0.58 according to Auger's electron spectrophotometry.

On the other hand, the composition of the silicon nitride film formed according to the reduced pressure CVD method by introducing $SiH_2Cl_2$ gas and $NH_3$ gas under the conditions of a reduced pressure of 0.3 Torr and a temperature of about 800 °C was found to be $Si_3N_4$ (Si/N = 0.75) which is approximately the stoichiometric ratio.

Also, the silicon nitride film formed by heat treatment at about 1200 °C in ammonia or $N_2$ (hot nitrification method) can be obtained with a composition further approximate to the stoichiometric ratio, since the formation method is performed under thermal equilibrium.

By use of silicon nitrides formed by the various methods as described above as the material for forming nucleation surface ($S_{NDL}$) with higher nucleation density than $SiO_2$, the above nucleus of Si can be grown on the nucleation surface ($S_{NDL}$) comprising silicon nitride to form Si single crystal based on the nucleation density ($\Delta$ND) corresponding to the chemical composition ratio of silicon nitride.

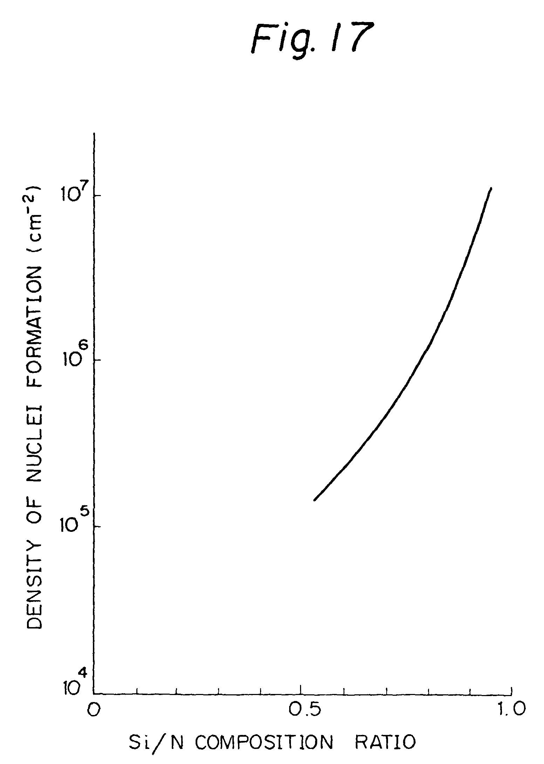

Fig. 17 is a graph showing the relationship between Si/N composition ratio and nucleation density (ND). As shown in the same graph, by varying the chemical composition ratio of the silicon nitride film, the nucleation density of the Si single crystal nucleus formed thereon changes to a great extent. The nucleation conditions in the graph shown in Fig. 17 correspond to the case when Si single crystal nucleus was formed by reacting $SiCl_4$ gas reduced to 175 Torr with $H_2$ at 1000°C. Of course, another graph will be obtained if nucleation conditions such as gas species, pressure, temperature, etc., are changed.

The phenomenon that the nucleation density thus changes according to the chemical composition ratio of silicon nitride affects the size (area) of the nucleation surface ($S_{NDL}$) when employing silicon nitride as the material for forming the nucleation surface ($S_{NDL}$) which is formed sufficiently finely to the extent that a single nucleus may be grown. That is, when employing silicon nitride having a composition with great nucleation density (ND) only a single crystal can be formed on the nucleation surface ($S_{NDL}$) by forming the nucleation surface ($S_{NDL}$) extremely finely as compared with the silicon nitride with relatively smaller nucleation density (ND).

Such a point is applicable as a similar tendency for other materials for forming nucleation surface ($S_{NDL}$).

Accordingly, in the present invention, for accomplishing its objects effectively, it is desirable to select a nucleation density (ND) and a size of nucleation surface ($S_{NDL}$) formed of silicon nitride, etc., capable of forming only a single crystal suitably as desired. For example, under the nucleation condition for obtaining a nucleation density (ND) of about $10^5$ cm$^{-2}$, it is possible to form selectively only a single nucleus, if the size of the nucleation surface ($S_{NDL}$) comprising silicon nitride is about 4 $\mu$m or less The Si/N ratio in that case is about 0.5.

(Formation of nucleation surface ($S_{NDL}$) by ion injection)

As another method for realizing nucleation density difference ($\Delta$ND) when forming Si single crystal nucleus, ion injection of Si, N, P, B, F, Ar, He, C, As, Ga, Ge, etc., may be effected locally onto the $SiO_2$ surface which is a material for forming non-nucleation surface ($S_{NDS}$) with smaller nucleation density to form a modified region with a desired size on the surface of the $SiO_2$ layer, and utilize this modified region as the nucleation surface ($S_{NDL}$) with greater nucleation density (ND).

For example, the $SiO_2$ layer surface is covered with a photoresist layer and the desired portions are exposed, developed, and dissolved to have the $SiO_2$ layer surface exposed.

Subsequently, by use of $SiF_4$ gas as the source gas, Si ions are implanted onto the $SiO_2$ layer surface portion exposed at 10 keV at a density of 1 x $10^{16}$ - 1 x $10^{18}$ cm$^{-2}$. The projected flying distance in this case is 114 Å, and the Si concentration on the exposed surface of $SiO_2$ layer reaches about $10^{22}$ cm$^{-3}$. Since the $SiO_2$ layer is originally amorphous, the modified region made excessively enriched in Si by injection of Si ions is also amorphous.

For formation of a modified region, ion injection can be effected with the use of a resist as the mask, but it is also possible to inject a narrowed Si ion beam selectively at a desired position on the $SiO_2$ layer surface within a desired area without use of a resist mark by use of converged ion beam technique.

After having thus effected Si ion injection, by peeling of the resist on the remaining portion, Si excessive modified region is formed in the $SiO_2$ layer surface portion at a desired position with a desired size. On the modified region of the $SiO_2$ layer surface portion having such modified region formed, Si single crystal is permitted to grow in vapor phase.

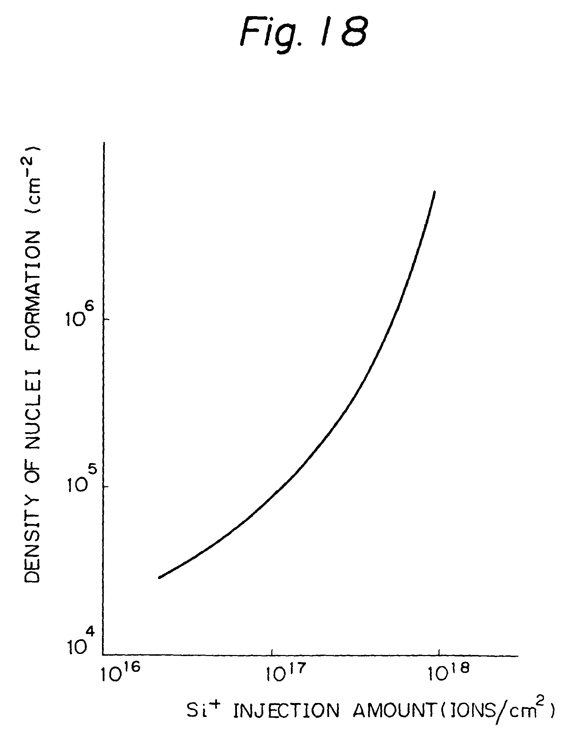

Fig. 18 is a graph showing the relationship between the injected amount of Si ions and the nucleation density (ND).

As shown in the same graph, it can be understood that nucleation density (ND) is increased as the $Si^+$ injected amount is more.

Therefore, by forming this modified region sufficiently finely, only single nucleus of Si can be permitted to grow with this modified region as the nucleation surface ($S_{NDL}$), whereby a single crystal can be grown as described above.

Formation of the modified region to a sufficiently fine size to the extent for growth of only a single nucleus can be accomplished easily by pattering of a resist, or narrowing of the beam of converged ion beam.

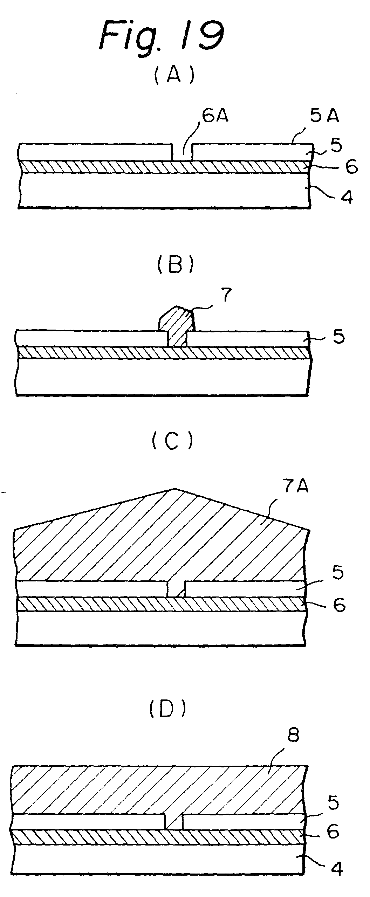

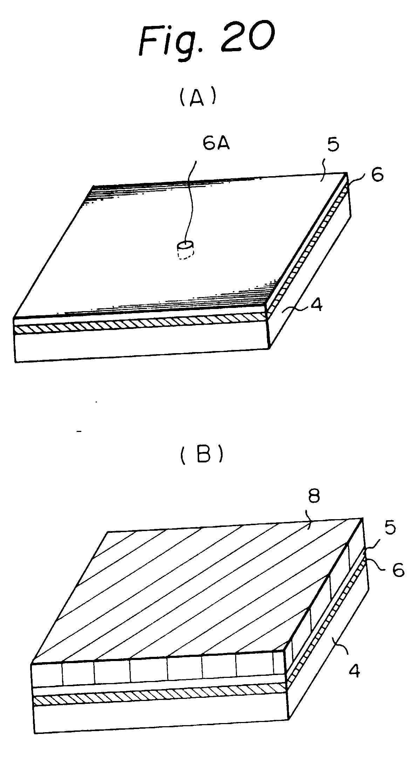

Figs. 19(A) - 19(D) are illustrations of the formation steps showing a 9th embodiment of the method for forming crystal according to the present invention, and Figs. 20(A) and 20(B) are perspective views corresponding to Figs. 19(A) and 19(D).

First, as shown in Fig. 19(A) and Fig. 20(A), on the base substrate 4 is formed a thin film 6 (or called "Seed") [forming nucleation surface ($S_{NDL}$)6A ] with greater nucleation density enabling selective nucleation, on which a material different from the material forming the thin film 6 with greater nucleation density is thinly deposited, followed by patterning according to lithography, etc., to form a thin film 5 comprising a different material and forming non-nucleation surface ($S_{NDS}$)5A so as to provide sufficiently finely nucleation surfaces ($S_{NDL}$)6A. However, the size, the crystal structure, and composition of the base substrate 4 may be chosen as desired, and it may be also a substrate having a functional device prepared according to conventional semiconductor technique formed thereon. Also, the nucleation surface ($S_{NDL}$)6A comprising a different material may be also formed as a modified region containing excessive Si, N or the like which may be formed by forming a thin film 6 beneath the $SiO_2$ thin film 5 of a polycrystalline silicon or $SiO_2$, and injecting ions of Si, N or the like into the exposed portions 6A.

Next, by selection of appropriate desposition conditions, a single nucleus of a crystal formation material is formed only on the nucleation surface ($S_{NDL}$)6A. That is, the nucleation surface ($S_{NDL}$)6A is required to be formed sufficiently minutely so that only a single nucleus may be formed thereon. The size of the nucleation surface ($S_{NDL}$)6A, which may differ depending on the kind of the material, may be several microns or less. Further, the nucleus grows while maintaining a single crystal structure to become a single crystal grain 7 in shape of an island as shown in Fig. 19(B). For forming an island-shaped single crystal grain 7, it is desirable to determine the conditions so that no nucleation may occur at all on the thin film 5A, as already mentioned.

The island-shaped single crystal grain 7 further grows while maintaining the single crystal structure with the nucleation surface ($S_{NDL}$)6A as the center (lateral over growth), whereby it can cover over the whole surface of the thin film 5 as shown in Fig. 19(C) (single crystal 7A).

Subsequently, if necessary, the single crystal 7a is flattened by etching or polishing, and a single crystal layer 8 capable of forming a desired device can be formed on the thin film 5 as shown in Fig. 19(D) and Fig. 20(B).

Thus, due to formation of the thin film 6 forming the nucleation surface ($S_{NDL}$)6A on the substrate 4, any desired material can be used for the substrate 4 which is the supporting member. Further, in such a case, even when the substrate 4 may be one having a functional device etc., formed thereon according to conventional semiconductor technique, the single crystal layer 8 can be easily formed thereon.

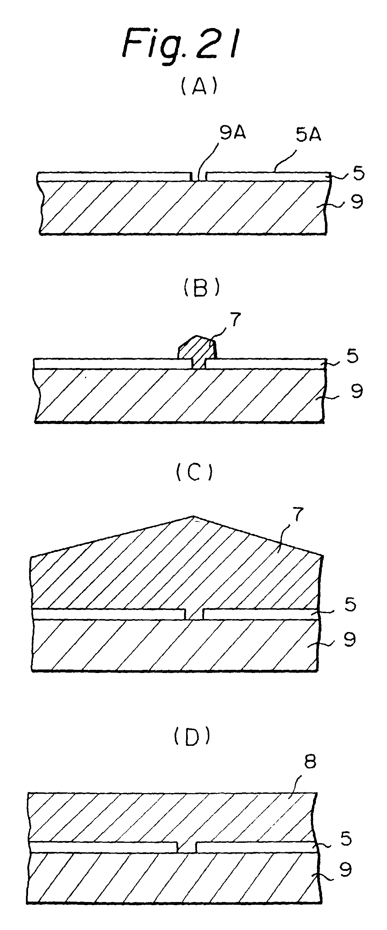

In the above embodiment, the nucleation surface ($S_{NDL}$)6A is formed of thin film 6, but a substrate comprising a material with large nucleation density (ND) enabling selective nucleation may be used as such and non-nucleation surfaces ($S_{NDS}$) may be provided at any desired positions to form single crystal layers similarly thereon as shown in Fig. 21.

Figs. 21(A) - 21(D) are illustration of the steps for forming crystal showing a second embodiment of the present invention. As shown in these figures on a substrate 9 comprising a material with large nucleation density (ND) enabling selective nucleation, a thin film 5 forming the non-nucleation surface ($S_{NDS}$)5A which comprises a material with small nucleation density (ND) can be formed so as to give exposed portions of the substrate 9 as nucleation surface ($S_{NDL}$) 9A sufficiently minutely to form a single crystal layer 8 by the use of said substrate similarly as in the first embodiment.

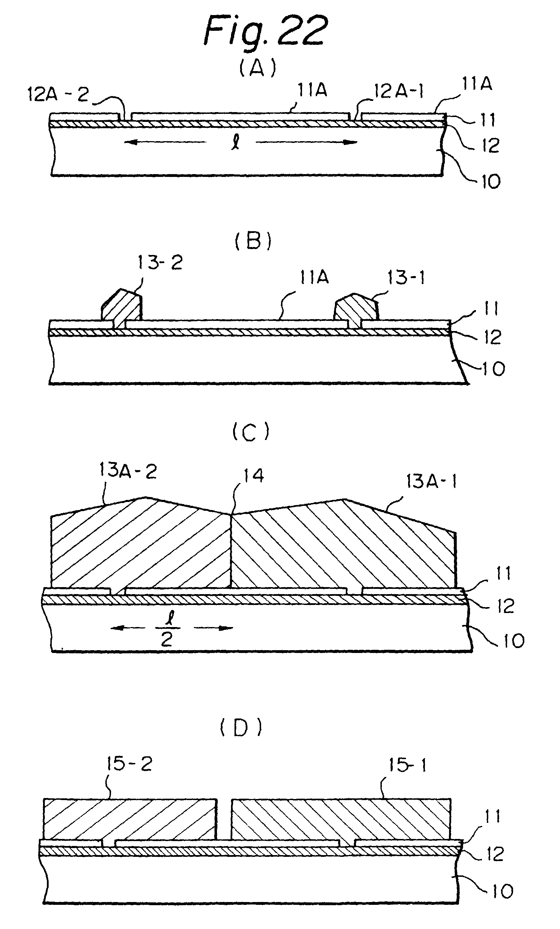

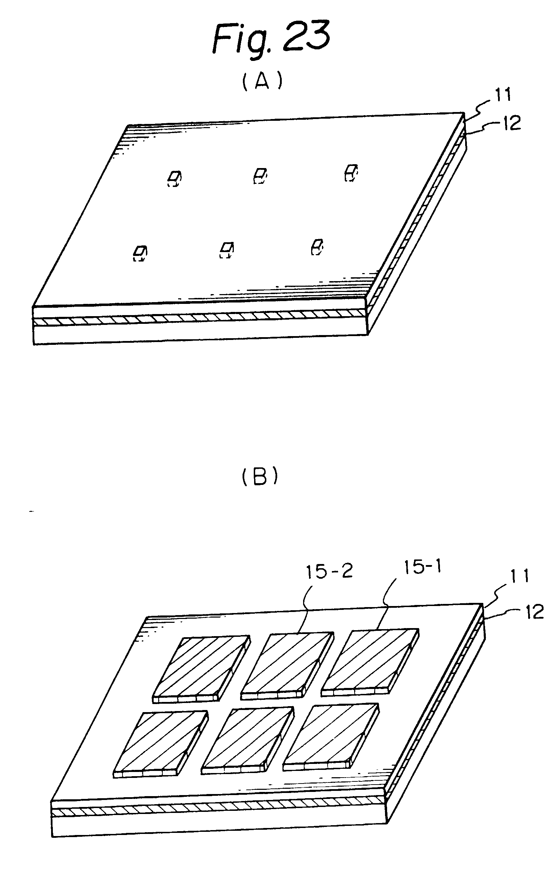

Figs. 22(A) - 22(D) are illustrations of the formation steps showing a 11th embodiment of the method for forming crystal according to the present invention, and Figs. 23(A) and 23(B) are perspective views corresponding to Figs. 22(A) and 22(D).

As shown in Fig. 22(A) and Fig. 23(A), on an appropriate base substrate 10 such as glass substrate, etc., an amorphous insulating thin film 12 with relatively greater nucleation density (ND) such as $Si_3N_4$, etc., is provided, and on said thin film 12 is formed selectively a thin film 11 at a desired position with a different material having smaller nucleation density relative to the material forming the thin film 12 which enables the above selective nucleation with an interval of a distance $\ell$, thereby arranging nucleation surfaces ($S_{NDL}$)12A-1, 12A-2 with sufficiently small areas so as to form only single nucleus thereon. This distance $\ell$ may be set at a size which is equal to or greater than the size of the single crystal region required for formation of a semiconductor device or a group of devices.

Next, by selecting appropriate crystal forming conditions, on the nucleation surfaces $(S_{NDL})$12A-1, 12A-2 only a nucleus of a crystal forming material is formed. That is, as described above, the nucleation surfaces 12A-1, 12A-2 are required to be formed to a sufficiently fine size (area) to the extent that only a single nucleus may be formed. The size of the nucleation surfaces $(S_{NDL})$12A-1, 12A-2, which may be different depending on the kind of the material, may be several microns or less. Further, the nucleus formed as above grows while maintaining the single crystal structure, and become island-shaped single crystal grains 13-1, 13-2 as shown in Fig. 22(B). For forming island-shaped single crystal grains 13-1, 13-2, it is desirable to determine the conditions so that substantially no nucleation may occur at all on other surfaces than the nucleation surfaces $(S_{NDL})$12A-1, 12A-2 [ non-nucleation surface $(S_{NDS})$11A ].

The crystal direction in the normal line d direction of the thin film 12 of the island-shaped single crystal grains 13-1, 13-2 is determined so as to make the interface energy of the material of the film 12 and the material forming nucleus minimum. For, surface or interface energy has anisotropy depending on the crystal face. However, as already mentioned, the crystal direction within the surface plane in amorphous surface is not determined.

The island-shaped single crystal grains 13-1, 13-2 further grow to become single crystals 13A-1, 13A-2 until the adjacent single crystals 13A-1, 13A-2 contact each other as shown in Fig. 22(C), but since the crystal directions within the substrate plane vary from one single crystal to another, a crystal grain boundary 14 is formed at the intermediate position between the nucleation surfaces $(S_{NDL})$ 12-1 and 12-2.

Subsequently, the single crystals 13A-1, 13A-2 grow three-dimensionally, but crystal faces with slow growth speed appear as the facet. For this reason, the surfaces of single crystals 13A-1, 13A-2 are flattened by etching or polishing, and further the portion of the grain boundary 14 is removed to form thin films of single crystals 15-1, 15-2, ... containing no grain boundary in shape of lattices as shown in Fig. 22(D) and Fig. 23(B). The size of the single crystal films 15-1, 15-2 is determined by the interval $\underline{1}$ between the nucleation surfaces $(S_{NDL})$12A-1, 12A-2 as described above. That is, by determining appropriately the formation pattern of the nucleation surface $(S_{NDL})$ 12A-1, 12A-2, the position of the grain boundary can be controlled to form single crystal with desired sizes at a desired arrangement.

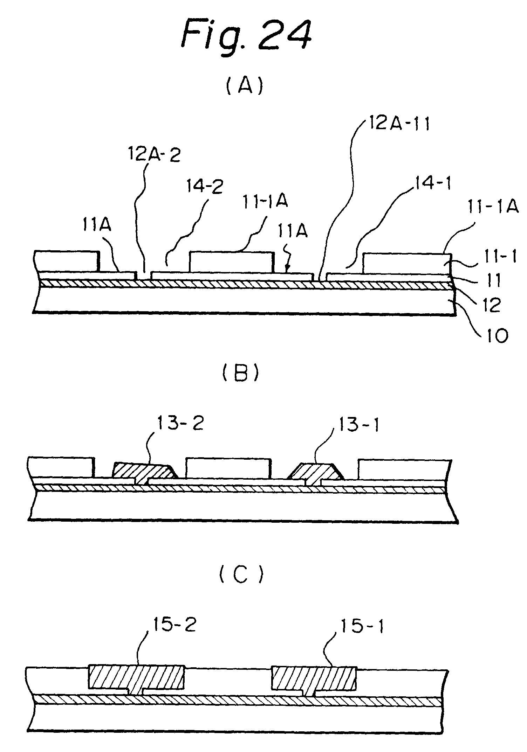

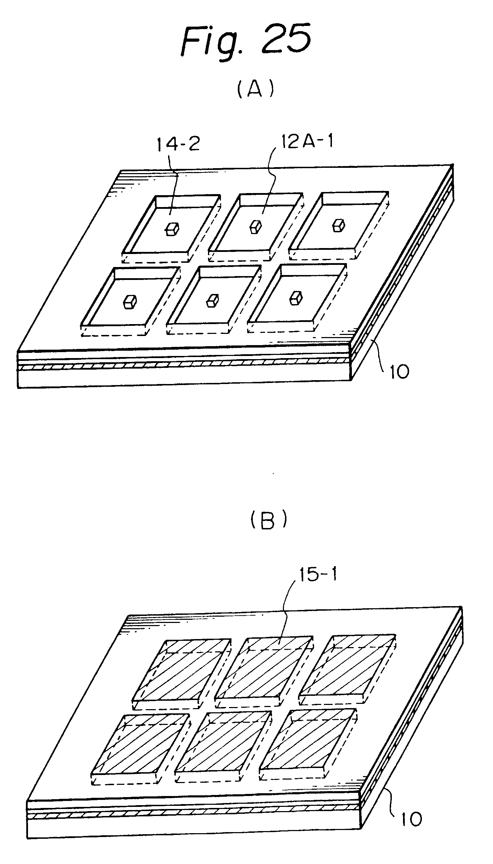

Figs. 24(A) - 24(C) are illustrations of the formation steps showing a 12th embodiment of the method for forming crystal according to the present invention, and Figs. 25(A) and 24(B) are perspective views of the substrates in Figs. 24(A) and 24(C).

First, as shown in Fig. 24(A) and Fig. 25(A), similarly as shown in the step (A) in Fig. 7, thin film 12 and 11 are provided on the base substrate 10 to form nucleation surfaces $(S_{NDL})$12A-1, 12A-2 and non-nucleation surface $(S_{NDS})$ 11A. Subsequently, so that concavities 14-1, 14-2 with desired sizes and shapes may be provided at the corresponding positions to the nucleation surfaces $(S_{NDL})$12A-1, 12A-2, a thin film 11-1 is formed with same material as the thin film 11a or a material having nucleation density equal to or smaller than said material. Thus, a substrate for formation of crystal having nucleation surfaces $(S_{NDL})$12A-1, 12A-2 with sufficiently fine sizes for forming only single nucleus within concavities 14-1, 14-2 is formded.

Subsequently, as shown in Fig. 24(B), island-shaped single crystal grains 13-1, 13-2 are grown similarly as in the first embodiment.

And, as shown in Fig. 24(C) and Fig. 25(B), single crystal grains 13-1, 13-2 are grown until embedding the concavity 14-1, 14-2 to form a single crystal layer 15-1, 15-2.

In this embodiment, since single crystal grains 13-1, 13-2 grow within the concavity 14-1, 14-2, the steps of flattening and remoing the grain portion may be unnecessary.

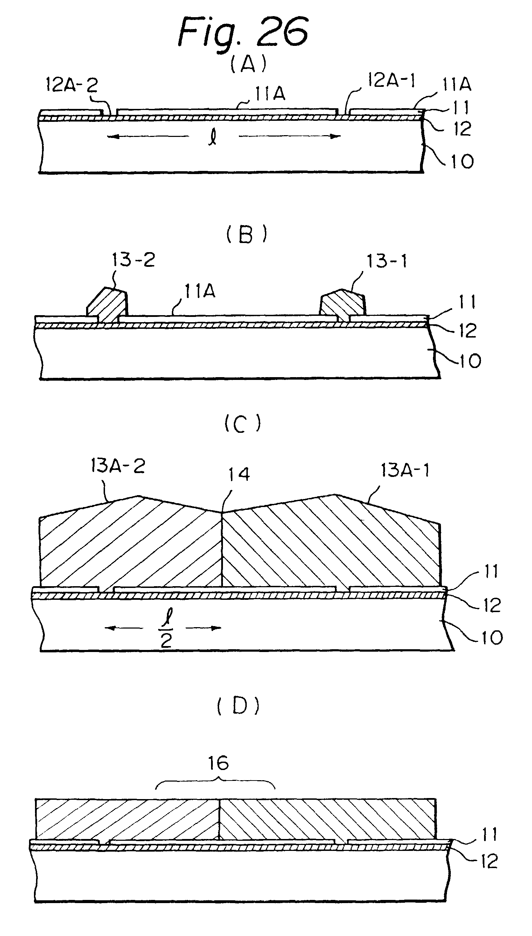

Figs. 26(A) - 26(D) are illustrations of the steps for forming crystal showing a 13th embodiment of the present invention.

Figs. 26(A) - 26(C) are the same as Figs. 22(A) - 22(C). That is, a plurality (two in the Figure) of nucleation surfaces 12A-1, 12A-2 are formed with an interval of $\underline{\ell}$, and single crystal grains 13-1, 13-2 subjected to over growth on the nucleation surfaces 12A-1, 12A-2 are formed. By permitting the single crystal grains 13-1, 13-2 to further grow to form single crystals 13A-1, 13A-2, a grain boundary 14 is formed approximately at the center between the non-nucleation surfaces $(S_{NDS})$11A, and by flattening the surface of single crystal 13A-1, 13A-2, a polycrystalline layer 16 with regular grain sizes which are approximately equal to $\underline{\ell}$ as shown in Fig. 12(D) can be obtained.

Since the grain size of the polycrystalline layer 16 is determined by the interval $\underline{\ell}$ between the nucleation surfaces $(S_{NDL})$12A-1, 12A-2, it becomes possible to control the grain size of the polycrystal. In the prior art, the grain size of a polycrystal was changed by a plural number of factors such as the formation method, formation temperature, etc., and also when preparing a polycrystal with large grain size, it had a grain size distribution with a considerable width. However, according to the present invention, the grain size and grain size distribution can be determined with good controllability by the interval $\underline{\ell}$ between the nucleation surfaces $(S_{NDL})$12A-1, 12A-2.

Of course, as shown in Fig. 21, a polycrystal layer may be formed as above by forming a thin film 5 having a non-nucleation surface $(S_{NDS})$5A with small nucleation density (ND) on a desired substrate 9 and plural nucleation surfaces $(S_{NDL})$9A with greater nucleation density (ND) at desired positions and intervals. In this case, as already mentioned, the substrate material and structure are not limited, provided that the nucleation density difference (ΔND) is taken into consideration, but the polycrystal layer can be formed by controlling the grain size and the grain size distribution.

The method of the present invention is described in more detail by use of Examples, but the present invention is not limited by these Examples.

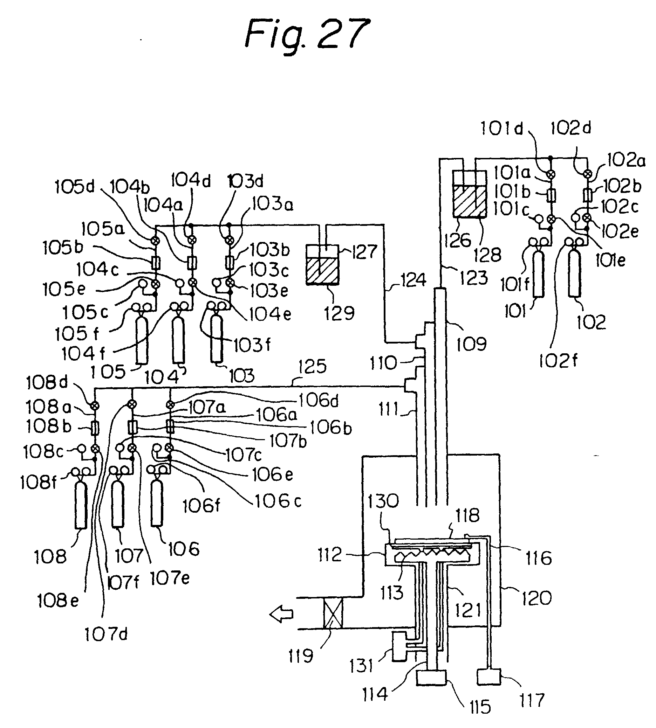

Fig. 27 shows one example of a preferable device for embodying the method for formation of a deposited film of the present invention.

The device for forming a deposited film shown in Fig. 27 is divided broadly into three parts of the main device, the discharging system and the gas feeding system.

The main device is provided with a film forming space.

101 to 108 are respectively bombs filled with the gases to be used during film formation. 101a-108a are respectively gas feeding pipes, 101b-108b are respectively mass flow controllers for controlling the flow rates of the gases from the respective bombs, 101c-108c are respectively gas pressure gauges, 101d-108d and 101e-108e are respectively valves, and 101f-108f are respectively pressure gauges indicating the pressures in the corresponding gas bombs.

120 is a vacuum chamber, having a structure such that a pipeline for introduction of gas is provided at the upper portion and a reaction space is formed downstream of the pipeline, and also having a structure such that a film forming space provided with a substrate holder 112 may be formed so that a substrate 118 may be placed as opposed to the gas introducing inlet of said pipeline. The pipeline for introduction of gas has a three-arrangement structure, having from the innerside a first gas introducing pipe 109 for introducing gases for the gas bombs 101, 102, a second gas introducing pipe 110 for introducing the gases from the gas bombs 103-105, and a third gas introducing pipe 111 for introducing the gases from the gas bombs 106-108.

Feeding of the gases from the bombs to the respective introducing pipes is done through the gas feeding pipelines 123-125, respectively.

The respective gas introducing pipes, the respective gas feeding pipelines and the vacuum chamber 120 are evacuated to vacuum by a vacuum evacuating device not shown through the main vacuum valve 119.

The substrate 118 can be set freely at any desired position relative to the respective gas introducing pipes by moving the substrate holder 112 vertically and in the directions of X and Y.

In the case of the method of the present invention, the distance between the substrate and the gas introducing inlet of the gas introducing pipe may be determined appropriately in view of the kinds of the deposited film to be formed, its desired characteristics, gas flow rates, the inner pressure of the vacuum chamber, etc., but it should preferably several mm to 20 cm, more preferably about 5 mm to 15 cm.

130 is a cooling pipe for cooling the substrate 118 if necessary, and it is connected to the flow rate controller 131.

113 is a heater for heating the substrate, which heats the substrate 118 to an appropriate temperature during film formation, preheats the substrate 118 before film formation, and further, after film formation, heats the film for annealing.

To the heater for heating the substrate 113 is fed power from the power source 115 through the wire 114.

116 is a thermocouple for measuring the temperature of the substrate (Ts) and is connected electrically to the temperature display device 117.

126 and 127 are bubblers for liquid starting materials, and used with filling of liquid starting materials for formation of a deposited film 128 and 129. When the starting materials for formation of a deposited film are gases under an ordinary state, it is not necessary to use bubblers for liquid starting materials.

Example 1

By means of the film forming device shown in Fig. 27, a deposited film according to the method of the present invention was prepared as described below.

$SiH_4$ gas filled in the bomb 101 was fed at a flow rate of 40 sccm through the gas introducing pipe 109, $F_2$ gas filled in the bomb 106 at a flow rate of 60 sccm and the He gas filled in the bomb 107 at a flow rate 120 sccm through the gas introducing pipe 111 into the vacuum chamber 120. In this Example, the bubblers 126 and 127 for liquid starting materials were not used.

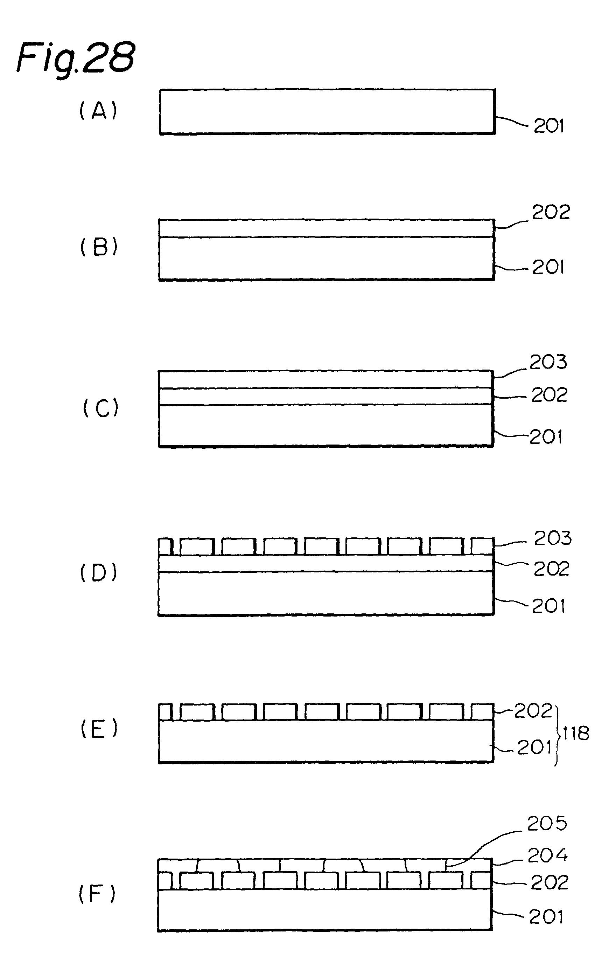

The substrate 118 was prepared according to the steps shown in Fig. 28.

First, a polycrystalline silicon substrate 201 as shown in Fig. 28(A) was washed, and subsequently silicon oxide thin film 202 was deposited on the whole surface of the substrate 1 according to the sputtering method (Figure 28(B)).

Subsequently, an electron beam resist layer 203 was formed on the thin film 202 (Figure 28(C)), and the electron beam resist layer 203 exposed to light by use of a photomask with a desired pattern and the electron beam resist layer 203 was partially removed by development (Figure 28(D)).

With the use of the remaining electron beam resist 203A as the mask, the silicon oxide thin film 202 was subjected to etching to form a thin film 202A with a desired pattern (Figure 28(E)).

According to the steps as described above, a substrate 118 with the crystal faces where a polycrystalline silicon exists were exposed at constant intervals from the silicon oxide film was obtained. The domains of the silicon crystal exposed on the substrate surface were about several handred angstroms in diameter, with intervals of 5 μm therebe-

tween.

Next, the vacuum chamber 120 was evacuated under sufficient baking by means of an evacuating device not shown to $5 \times 10^{-9}$ Torr. $SiH_4$ gas filled in the bomb 101 was permitted to flow at a flow rate of 4 sccm through the gas introducing pipe 109 into the vacuum chamber 120.

On the other hand, $F_2$ gas (diluted to 10 % with He) filled in the bomb 107 was introduced at 4 sccm through the gas introducing pipe 111 into the vacuum chamber 120. The evacuation rate at this time was controlled to 0.8 m Torr/sec by controlling the evacuating valve 119, and after this state was maintained for 10 hrs., the valves 101d and 107a were closed to stop feeding of gases, and the vacuum degree was controlled at 0.004 Torr by opening the evacuation valve 119. Thereafter, the vacuum was broken to take out the substrate 118 on which the film was formed.

Fig. 28(F) shows schematically the cross-section of the crystalline silicon deposited film obtained on the substrate 118.

The size of the crystal grain 204 was determined so that the crystal grain bounderies 205 became equidistant from the exposed portions of the crystal substrate 201 at which the silicon oxide layer 202 was removed.

Further by the use of the respective samples obtained, crystallinity of the deposited films was evaluated by the X-ray diffraction method and the electron beam diffraction method, whereby they were confirmed to be polycrystalline films. Further, the grain size of the polycrystalline silicon was found to be about $5 \pm 0.2$ μm by means of the Scherrar method. Variance in crystal grain sizes was uniform over the whole surface of the substrate.

When the surface state of the samples was observed by a scanning type electron microscope, the smoothness was good without wavy pattern, etc., and the film thickness irregularity $\underline{t}$ was $\pm$ 4 % or less. also, the mobility and conductivity of the crystalline Si deposited film of the obtained samples was measured by the Van der Pauw method to be 300 (cm/V sec), $9 \times 10^{-6}$ (S cm$^{-1}$), respectively.

Example 2

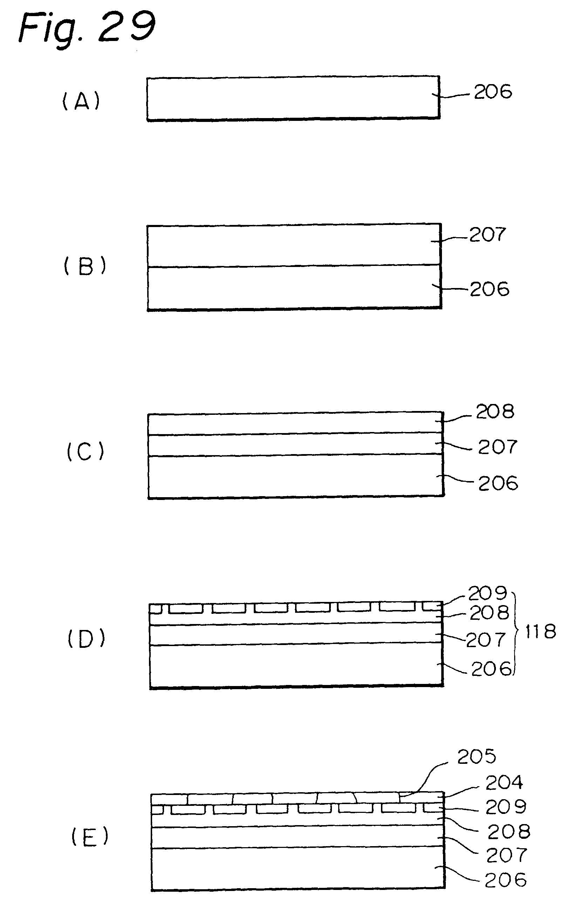

The substrate 118 was prepared according to the steps shown in Fig. 29.

First, a glass base plate 206 of a material having substantially uniform composition as shown in Fig. 29(A) was washed and then an amorphous SiN(A-SiN) thin film 207 was formed with a thickness of about 2 pm on the whole surface of the base plate 206 (Figure 28(B)) by means of thermal CVD.

Subsequently, surface annealing of the above A-SiN thin film 207 was effected in $N_2$ atmosphere by means of a laser annealing device on the A-SiN thin film 207 to form crystalline $Si_3N_4$ (C-$Si_3N_4$) 208 in the surface layer (about 1 μm deep of the A-SiN thin film 207 to 1 μm (Figure 29(C)).

For the laser used at this time, a puls width was 50 nsec, an average power density 100 m J/cm$^2$, and the laser was irradiated at 40 pu/se. Subsequently, the surface of the C-$Si_3N_4$ layer 208 was scanned by means of the above laser annealing device in $O_2$ atmosphere to form selectively the $SiO_2$ layer 209 (Figure 29(D)).

According to the steps as described above, a substrate 118 having C-$Si_3N_4$ layer exposed at constant intervals with others portions being covered with $SiO_2$ layer was formed. The domains of C-$Si_3N_4$ layer exposed on the substrate surface were about 4Å in width with intervals of 3 μm therebetween.

Further, by use of this substrate 118, crystalline silicon was deposited by means of the device shown in Fig. 27 similarly as described in Example 1.

First, the vacuum chamber 120 was evacuated under sufficient baking by means of an evacuation device not shown to $5 \times 10^{-9}$ Torr. $SiH_4$ gas filled in the bomb 101 was permitted to flow at a flow rate of 5 sccm into the vacuum chamber 120 through the gas introducing pipe 109 by controlling the evacuating valve 119. At the same time, $F_2$ gas (diluted to 10 % with He) filled in the bomb 107 was introduced at 6 sccm through the gas introducing pipe 111 into the vacuum chamber 120. The evacuation rate at this time was made 0.8 m Torr/sec by controlling the evacuation valve 119, and after this state was maintained for 20 hrs., the valves 101d and 107a were closed to stop feeding of the gases, and the state controlled to vacuum of 0.01 Torr was maintained by opening the evacuation valve 119 for same time.

Thereafter, the vacuum was broken to take out the substrate 118 on which the film was formed.

Fig. 29(F) shows schematically the cross-section of the crystalline silicon deposited film obtained on the substrate 118.

The size of the crystal grain 204 is determined so that the crystal grain boundaries 205 became equidistant from the exposed portions of the crystal substrate 201 other than the $SiO_2$ layer 209.

Further, by use of the respective samples obtained, crystallinity of the deposited film was evaluated by the X-ray diffraction method and the electron beam diffraction method, whereby they were confirmed to be polycrystalline silicon films.

Further, the grain size of the polycrystalline silicon determined by the Scherrar method was found to be about $3 \pm 0.5$ μm. Variance in crystal grain sizes was uniform over the whole surface of the substrate.

When the surface state of the sample was observed by a scanning type electron microscope, the smoothness was good without wavy pattern, etc., and the film thickness irregularity was ±4 % or less. Also, the mobility and conductivity of the crystalline Si deposited film of the obtained samples was measured by the Van der Pauw method to be 150 (cm/V sec), $4 \times 10^{-6}$ (S cm$^{-1}$), respectively.

Example 3

As the substrate, Corning #7059 glass substrate (size 5 cm x 5 cm, thickness 0.5 mm) was used, and a nitride film containing 15% of hydrogen was deposited to about 150 Å on the surface of said substrate according to the grow discharge method at a substrate temperature of 250 °C. Next, a photoresist was applied to the above nitride film and after baking with a pattern of 1 μ square and 10 μ pitch as shown in Fig. 21(A), the nitride film was removed by etching with a mixture of hydrofluoric acid and water with only the above 1 μ square portions being permitted to remain. Then, after removal of the resist, the substrate was sufficiently washed and dried. Thus, a substrate for formation of a deposited film was prepared.

By use of this substrate, a deposited film was prepared according to the method of the present invention as described below by means of the film forming device showing in Fig. 27.

The SiH$_4$ gas filled in the bomb 101 was introduced at a flow rate of 30 sccm through the gas introducing pipe 109, the B$_2$H$_6$ gas (diluted to 5000 ppm with He gas) filled in the bomb 103 at flow rates of 0.5 sccm, 5 sccm, and 50 sccm through the gas introducing pipe 110, the F$_2$ gas filled in the bomb 106 at a flow rate of 40 sccm, and the He gas filled in the bomb 107 at a flow rate of 100 sccm through the gas introducing pipe 111 into the vacuum chamber 120.

During this operation, the pressure within the vacuum chamber 120 was made 0.5 Torr by controlling the opening of the vacuum valve 119. The distance between the gas introducing inlet 111 and the substrate was set at 5 cm. Bluish white luminescence was strongly obtained in the mixing region of SiH$_4$ gas and F$_2$ gas. The substrate temperature (Ts) was set at 250 °C.

When gases were permitted to flow under this state for 1 hour, a silicon deposited film of 15 μm was formed in a pattern as shown in Fig. 21(C) on the substrate.

When crystallinity of the deposited film of the silicon obtained was evaluated according to the S-ray diffraction method, it was confirmed that substantially perfect single crystals had grown from the portions where the respective nucleation surfaces (S$_{NDL}$) were formed and there was little lattice defect.

Also, when the surface state was observed by a scanning type electron microscope, the smoothness was good without wavy pattern, etc., and the film thickness irregularity was also ±5% or less.

When the doping characteristics of the respective samples at room temperature were evaluated according to the van der Pauw method, the results shown in Table 1 were obtained. These results show that good p-type doping has been effected.

Table 2

| Kind and flow rate of doping gas | σd (s · cm$^{-1}$) | Positive whole mobility (cm/V · sec) | Carrier density (cm$^{-1}$) |
|---|---|---|---|
| PH$_3$ (6000 ppm He dilution) 0.5 sccm | $1.0 \times 10^{-3}$ | 935 | $3.5 \times 10^{16}$ |
| PH$_3$ (6000 ppm He dilution) 5 sccm | $1.5 \times 10^{-2}$ | 770 | $2.0 \times 10^{17}$ |
| PH$_3$ (6000 ppm He dilution) 50 sccm | $1.0 \times 10^{-1}$ | 215 | $1.0 \times 10^{18}$ |

The method for forming deposited film of the present invention can form a deposited film only by contacting a gaseous starting material with a gaseous halogen oxidizing agent, and has the advantage of requiring particularly no reaction exciting energy from the outside. Accordingly, it becomes also possible to lower the substrate temperature. Also, since a material which becomes the crystal nucleus for the deposited film or capable of forming selectively the crystal nucleus can be arranged at a desired position on the substrate surface, any desired crystalline deposited film can be formed. Further, simultaneously with saving of energy, it is possible to obtain a crystalline deposited film having uniform film quality and characteristics over a large area with easy management of the film quality. Further, a crystalline film excellent in productivity and mass productivity, and having high quality with excellent electrical, optical, semiconductive, and other physical properties can be obtained with ease.

## Claims

1. A method for forming a crystalline material by deposition, comprising:

   establishing at a free surface of a substrate a plurality of deposition surface areas (2; 6; 12; 6A; 9A; 12A) each being of a different composition from that of the adjacent deposition surface area (5; 11; 18; 20; 11A) and having under chosen conditions of deposition a property of nucleating a crystal forming material at a higher nucleation density than that of the adjacent deposition surface area and each of the deposition surface areas being at spaced apart locations on the substrate separated by said adjacent deposition surface areas; and depositing said crystal forming material on the exposed free surface of the substrate so that said crystal forming material nucleates selectively on said deposition surface areas;

   characterised in that:

   (a) said deposition surface areas have surface properties which exclude an epitaxial growth of a single crystal of said crystal forming material;
   (b) each of said deposition surface areas is limited to a size such that said crystal forming material forms on each deposition surface area under said chosen conditions of deposition one single nucleus of supracritical size (Figure 1) which grows into one single crystal; and
   (c) the deposition of said crystal forming material is performed by introducing a gaseous starting material and a gaseous halogen oxidizing agent, having a property of oxidative action on said starting material, into a reaction chamber containing said substrate, whereby upon mutual contact said starting material and said agent interact to form a plurality of active species, at least one of these active species providing a source of said crystal forming material.

2. A method as claimed in claim 1 wherein said deposition surface areas (6A; 9A; 12A;) are located below said adjacent deposition surface area and each is exposed through an aperture therein.

3. A method as claimed in claim 1, wherein said one or more deposition surface areas (2; 6; 12) are located above said adjacent deposition surface area.

4. A method as claimed in claim 1, 2 or 3, wherein said deposition surface areas are areas of a film of a material different in composition from that material of said adjacent deposition surface area.

5. A method as claimed in claim 4, wherein said deposition surface areas are areas of silicon nitride and said adjacent deposition surface area is an area of silicon oxide.

6. A method as claimed in claim 1, wherein said deposition surface areas are established by a modification of that material which is to provide said adjacent deposition surface area.

7. A method as claimed in claim 6, wherein said modification is performed by ion implantation.

8. A method as claimed in any one of the preceding claims wherein said adjacent deposition surface area is an area of amorphous material.

9. A method as claimed in any one of the preceding claims, wherein said deposition of said crystal forming material is discontinued before each single crystal comes into contact with any other (Fig 10, 11, 12, 13, 24, 25).

10. A method as claimed in claim 9, wherein each single crystal is grown from the respective deposition surface area over said adjacent deposition surface area.

11. A method as claimed in any one of claims 1 to 8, wherein said deposition of said crystal forming material is continued at least until each single crystal comes into contact with and adjoins those adjacent thereto and a polycrystalline film (205) is formed of the adjoined single crystals (Fig 28, 29).

12. A method as claimed in any one of the preceding claims wherein said starting material is a chain silane compound.

13. A method as claimed in claim 12, wherein said compound is a straight chain silane compound.

**14.** A method as claimed in claim 13, wherein said compound is given by the formula: $Si_nH_{2n+2}$, where n is 1 to 8

**15.** A method as claimed in claim 12, wherein said compound is a branched chain silane compound.

**16.** A method as claimed in any one of the preceding claims 1-11 wherein said starting material is a cyclic silane compound.

**17.** A method as claimed in any one of claims 1-16, wherein said gaseous halogen oxidizing agent is fluorine gas.

**18.** A method as claimed in any one of claims 1-16, wherein said gaseous oxidizing agent is chlorine gas.

**19.** A method as claimed in any one of the preceding claims 1-16 wherein said gaseous halogen oxidizing agent contains fluorine atoms as a constituent.

**Patentansprüche**

**1.** Verfahren zur Bildung eines kristallinen Materials durch Abscheidung, bei dem

an einer freien Oberfläche eines Substrats mehr als ein Abscheidungsoberflächenbereich (2; 6; 12; 6A; 9A; 12A) hergestellt wird, wobei jeder eine Zusammensetzung hat, die von der des benachbarten Abscheidungsoberflächenbereichs (5; 11; 18; 20; 11A) verschieden ist, und unter ausgewählten Abscheidungsbedingungen die Eigenschaft hat, daß aus einem kristallbildenden Material Kristallkeime mit einer Keimbildungsdichte gebildet werden, die höher ist als die des benachbarten Abscheidungsoberflächenbereichs, und wobei sich alle Abscheidungsoberflächenbereiche an mit Abstand angeordneten Stellen auf dem Substrat befinden, die durch die erwähnten benachbarten Abscheidungsoberflächenbereiche getrennt sind; und

das erwähnte kristallbildende Material auf der freiliegenden freien Oberfläche des Substrats abgeschieden wird, so daß das erwähnte kristallbildende Material selektiv auf den erwähnten Abscheidungsoberflächenbereichen Kristallkeime bildet; dadurch gekennzeichnet, daß

(a) die erwähnten Abscheidungsoberflächenbereiche Oberflächeneigenschaften haben, die ein epitaxiales Aufwachsen eines Einkristalls aus dem erwähnten kristallbildenden Material ausschließen;

(b) jeder der erwähnten Abscheidungsoberflächenbereiche auf eine derartige Größe beschränkt ist, daß das erwähnte kristallbildende Material unter den erwähnten ausgewählten Abscheidungsbedingungen auf jedem Abscheidungsoberflächenbereich einen einzigen Kristallkeim mit überkritischer Größe (Figur 1) bildet, der zu *einem* Einkristall heranwächst; und

(c) die Abscheidung des erwähnten kristallbildenden Materials durchgeführt wird, indem in eine Reaktionskammer, die das erwähnte Substrat enthält, ein gasförmiges Ausgangsmaterial und ein gasförmiges Halogen-Oxidationsmittel, das die Eigenschaft einer oxidativen Wirkung auf das erwähnte Ausgangsmaterial hat, eingeleitet werden, wodurch das erwähnte Ausgangsmaterial und das erwähnte Oxidationsmittel beim gegenseitigen Kontakt unter Bildung mehr als einer aktiven Spezies aufeinander einwirken, wobei mindestens eine dieser aktiven Spezies eine Quelle des erwähnten kristallbildenden Materials bereitstellt.

**2.** Verfahren nach Anspruch 1, bei dem sich die erwähnten Abscheidungsoberflächenbereiche (6A; 9A; 12A) unter dem erwähnten benachbarten Abscheidungsoberflächenbereich befinden und jeder durch eine darin befindliche Öffnung freigelegt ist.

**3.** Verfahren nach Anspruch 1, bei dem sich der erwähnte eine oder mehr als eine Abscheidungsoberflächenbereich (2; 6; 12) über dem erwähnten benachbarten Abscheidungsoberflächenbereich befindet.

**4.** Verfahren nach Anspruch 1, 2 oder 3, bei dem die erwähnten Abscheidungsoberflächenbereiche Bereiche eines Films aus einem Material sind, das sich in der Zusammensetzung von dem Material des erwähnten benachbarten Abscheidungsoberflächenbereichs unterscheidet.

**5.** Verfahren nach Anspruch 4, bei dem die erwähnten Abscheidungsoberflächenbereiche Bereiche aus Siliciumnitrid sind und der erwähnte benachbarte Abscheidungsoberflächenbereich ein Bereich aus Siliciumoxid ist.

6. Verfahren nach Anspruch 1, bei dem die erwähnten Abscheidungsoberflächenbereiche durch eine Modifizierung des Materials, das zur Bereitstellung des erwähnten benachbarten Abscheidungsoberflächenbereichs dient, hergestellt werden.

7. Verfahren nach Anspruch 6, bei dem die erwähnte Modifizierung durch Ionenimplantation durchgeführt wird.

8. Verfahren nach einem der vorhergehenden Ansprüche, bei dem der erwähnte benachbarte Abscheidungsoberflächenbereich ein Bereich aus amorphem Material ist.

9. Verfahren nach einem der vorhergehenden Ansprüche, bei dem die erwähnte Abscheidung des erwähnten kristallbildenden Materials abgebrochen wird, bevor jeder Einkristall mit irgendeinem anderen in Kontakt kommt (Fig. 10, 11, 12, 13, 24, 25).

10. Verfahren nach Anspruch 9, bei dem jeder Einkristall aus dem jeweiligen Abscheidungsoberflächenbereich über den erwähnten benachbarten Abscheidungsoberflächenbereich gezüchtet wird.

11. Verfahren nach einem der Ansprüche 1 bis 8, bei dem die erwähnte Abscheidung des erwähnten kristallbildenden Materials mindestens fortgesetzt wird, bis jeder Einkristall mit denen, die ihm benachbart sind, in Kontakt kommt und daran anstößt und aus den aneinander anstoßenden Einkristallen ein polykristalliner Film (205) gebildet ist (Fig. 28, 29).

12. Verfahren nach einem der vorhergehenden Ansprüche, bei dem das erwähnte Ausgangsmaterial eine kettenförmige Silanverbindung ist.

13. Verfahren nach Anspruch 12, bei dem die erwähnte Verbindung eine geradkettige Silanverbindung ist.

14. Verfahren nach Anspruch 13, bei dem die erwähnte Verbindung durch die folgende Formel gegeben ist: $Si_nH_{2n+2}$, worin n 1 bis 8 ist.

15. Verfahren nach Anspruch 12, bei dem die erwähnte Verbindung eine verzweigtkettige Silanverbindung ist.

16. Verfahren nach einem der vorhergehenden Ansprüche 1 bis 11, bei dem das erwähnte Ausgangsmaterial eine cyclische Silanverbindung ist.

17. Verfahren nach einem der Ansprüche 1 bis 16, bei dem das erwähnte gasförmige Halogen-Oxidationsmittel Fluorgas ist.

18. Verfahren nach einem der Ansprüche 1 bis 16, bei dem das erwähnte gasförmige Oxidationsmittel Chlorgas ist.

19. Verfahren nach einem der vorhergehenden Ansprüche 1 bis 16, bei dem das erwähnte gasförmige Halogen-Oxidationsmittel Fluoratome als Bestandteil enthält.

**Revendications**

1. Procédé de formation d'une matière cristalline par dépôt, comprenant :

l'établissement, sur une surface libre d'un substrat, d'une pluralité d'aires de dépôt (2 ; 6 ; 12 ; 6A ; 9A ; 12A) étant chacune d'une composition différente de celle de l'aire de dépôt adjacente (5 ; 11 ; 18 ; 20 ; 11A) et ayant, dans des conditions de dépôt choisies, une propriété de nucléation d'une matière formant un cristal à une plus haute densité de nucléation que l'aire de dépôt adjacente et chacune des aires de dépôt occupant des positions espacées sur le substrat séparées par lesdites aires de dépôt adjacentes ; et
le dépôt de la matière formant un cristal sur la surface libre exposée du substrat de manière que ladite matière formant un cristal produise des germes sélectivement sur les aires de dépôt ;

caractérisé en ce que :

(a) les aires de dépôt ont des propriétés de surface qui excluent une croissance épitaxiale d'un monocristal de ladite matière formant un cristal ;

(b) chacune des aires de dépôt est limitée à des dimensions telles que la matière formant un cristal en question forme sur chaque aire de dépôt, dans les conditions de dépôt choisies, un unique germe de dimensions supracritiques (figure 1) qui se développe en formant un monocristal ; et

(c) le dépôt de la matière formant un cristal est effectué par introduction d'une matière de départ gazeuse et d'un agent oxydant halogéné gazeux, ayant la propriété d'agir par oxydation sur la matière de départ en question, dans une chambre de réaction contenant ledit substrat, de sorte que par contact mutuel, la matière de départ et l'agent en question interagissent en formant une pluralité d'entités actives dont l'une au moins constitue une source de ladite matière formant un cristal.

2. Procédé suivant la revendication 1, dans lequel les aires de dépôt (6A ; 9A ; 12A) sont disposées au-dessous de l'aire de dépôt adjacente et chacune d'elles est exposée à travers une ouverture qui y est ménagée.

3. Procédé suivant la revendication 1, dans lequel l'aire ou les aires de dépôt (2 ; 6 ; 12) sont situées au-dessus de l'aire de dépôt adjacente en question.

4. Procédé suivant la revendication 1, 2 ou 3, dans lequel les aires de dépôt sont des aires d'un film d'une matière dont la composition diffère de celle de l'aire de dépôt adjacente.

5. Procédé suivant la revendication 4, dans lequel les aires de dépôt sont des aires en nitrure de silicium et l'aire de dépôt adjacente est une aire en oxyde de silicium.

6. Procédé suivant la revendication 1, dans lequel les aires de dépôt sont établies par une modification de la matière qui doit constituer l'aire de dépôt adjacente.

7. Procédé suivant la revendication 6, dans lequel la modification est effectuée par implantation d'ions.

8. Procédé suivant l'une quelconque des revendications précédentes, dans lequel l'aire de dépôt adjacente est une aire formée de matière amorphe.

9. Procédé suivant l'une quelconque des revendications précédentes, dans lequel le dépôt de la matière formant un cristal est interrompu avant que chaque monocristal entre en contact avec tout autre (figures 10, 11, 12, 13, 24, 25).

10. Procédé suivant la revendication 9, dans lequel chaque monocristal se développe à partir de l'aire de dépôt réactive sur l'aire de dépôt adjacente.

11. Procédé suivant l'une quelconque des revendications 1 à 8, dans lequel le dépôt de la matière formant le cristal est poursuivi au moins jusqu'à ce que chaque monocristal entre en contact avec, et se joigne avec, ceux qui y sont adjacents, et un film polycristallin (205) est formé des monocristaux réunis (figures 28, 29).

12. Procédé suivant l'une quelconque des revendications précédentes, dans lequel la matière de départ est un silane en chaîne.

13. Procédé suivant la revendication 12, dans lequel le composé est un silane en chaîne droite.

14. Procédé suivant la revendication 13, dans lequel le composé répond à la formule :
$Si_nH_{2n+2}$, dans laquelle $\underline{n}$ a une valeur de 1 à 8.

15. Procédé suivant la revendication 12, dans lequel le composé est un silane à chaîne ramifiée.

16. Procédé suivant l'une quelconque des revendications 1 à 11, dans lequel la matière de départ est un silane cyclique.

17. Procédé suivant l'une quelconque des revendications 1 à 16, dans lequel l'agent oxydant halogéné gazeux est du fluor gazeux.

18. Procédé suivant l'une quelconque des revendications 1 à 16, dans lequel l'agent oxydant gazeux est du chlore gazeux.

19. Procédé suivant l'une quelconque des revendications 1 à 16 précédentes, dans lequel l'agent oxydant halogéné gazeux contient des atomes de fluor comme constituant.

# Fig. 1

# Fig. 2

(A)

(B)

# Fig. 3

# Fig. 4

(A)

(B)

(C)

(D)

# *Fig. 5*

## (A)

## (B)

# Fig. 6

(A)

6

9

(B)

7

(C)

7A

(D)

8

9

# Fig. 7

(A)

(B)

(C)

(D)

# Fig. 8

## (A)

## (B)

# Fig. 9

(A)

12-2  12-1  5

4

$l$

(B)

13-2  13-1  5

4

(C)

13A-2  14  13A-1

5

$\dfrac{l}{2}$  4

(D)

15  15

5

4

# Fig. 10

(A)

(B)

(C)

# Fig. 11

## (A)

## (B)

# Fig. 12

(A)

(B)

(C)

# Fig. 13

(A)

(B)

(C)

# Fig. 14

# Fig. 15

## (A)

12             12

$\ell$

11

## (B)

13          13

11

## (C)

13A    14    13A

$\dfrac{\ell}{2}$

11

## (D)

21

11

# Fig. 16

# Fig. 17

# Fig. 18

# Fig. 19

(A)

(B)

(C)

(D)

# Fig. 20

## (A)

## (B)

# Fig. 21

## (A)

## (B)

## (C)

## (D)

# Fig. 22

## (A)

12A-2    11A    12A-1    11A
11
12
10
$\ell$

## (B)

13-2    11A    13-1
11
12
10

## (C)

13A-2    14    13A-1
11
12
10
$\dfrac{\ell}{2}$

## (D)

15-2    15-1
11
12
10

# Fig. 23

## ( A )

## ( B )

# Fig. 24

(A)

(B)

(C)

# Fig. 25

## (A)

14-2 12A-1

10

## (B)

15-1

10

# Fig. 26

## (A)

## (B)

## (C)

## (D)

# Fig. 27

# Fig.28

(A) ——— 201

(B)
——— 202
——— 201

(C)
——— 203
——— 202
——— 201

(D)
——— 203
——— 202
——— 201

(E)
——— 202 }
——— 201 } 118

(F)
——— 205
——— 204
——— 202
——— 201

# Fig. 29

(A) — 206

(B)
— 207
— 206

(C)
— 208
— 207
— 206

(D)
209
208 } 118
207
206

(E)
205
204
209
208
207
206